# EUROPEAN PATENT APPLICATION

(11) **EP 4 694 173 A1**
(43) Date of publication of application: **11.02.2026**
(21) Application number: 24779649.3
(22) Date of filing: 18.03.2024
(51) Int. Cl.: H04N 25/77, H01L 27/146, H04N 25/79

(54) **PHOTODETECTOR AND ELECTRONIC APPARATUS**

(30) Priority: 24.03.2023 JP 2023048586
(71) Applicant: Sony Semiconductor Solutions Corporation, Atsugi-shi, Kanagawa 243-0014 (JP)
(72) Inventor: AOTA Tomoya, Atsugi-shi, Kanagawa 243-0014 (JP); BANDO Masashi, Atsugi-shi, Kanagawa 243-0014 (JP); KUMAGAI Yoshimichi, Atsugi-shi, Kanagawa 243-0014 (JP); OSAWA Naoyuki, Atsugi-shi, Kanagawa 243-0014 (JP); ABE Takashi, Atsugi-shi, Kanagawa 243-0014 (JP); AKIYAMA Shunya, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/010508
(87) International publication number: WO 2024/203524

(57) **Abstract**

It is possible to achieve higher resolution and improve image quality of captured images. A light detection device includes a plurality of second pixel circuits that are shared by each of two or more first pixel circuits, each second pixel circuit includes: a first capacitative element configured to hold a voltage signal output from a corresponding pixel in a state where an electric charge of a first floating diffusion region of the pixel has been initialized; a second capacitative element configured to hold a voltage signal output from the corresponding pixel in a state where an accumulated charge of the photoelectric conversion element has been transferred to the first floating diffusion region of the pixel; a first transistor configured to switch between whether or not to transfer an electric charge held in the first capacitative element to a second floating diffusion region shared by the two or more first pixel circuits; and a second transistor configured to switch between whether or not to transfer an electric charge held in the second capacitative element to the second floating diffusion region, and in the second pixel circuit, two or more of the first transistors and two or more of the second transistors included in the two or more first pixel circuits are arranged in point symmetry or line symmetry around one third transistor.

## Description

### [Technical Field]

The present disclosure relates to a light detection device and an electronic apparatus.

### [Background Art]

Imaging devices that employ a rolling shutter system, in which exposure times are staggered in pixel row units, have a problem in that mobile body images in captured images are distorted images. In consideration thereof, imaging devices that employ a global shutter system, in which exposure is started simultaneously by all pixels, are proposed (refer to PTL 1).

### [Citation List]

### [Patent Literature]

[PTL 1]
WO 2021/215105

### [Summary]

### [Technical Problem]

Since the global shutter system requires that each pixel be provided with an electric charge holding portion for holding an accumulated charge of a photoelectric conversion element of each pixel, an increased pixel size becomes an obstacle to higher resolution. In addition, innovation is necessary to ensure that the electric charge holding portion is not affected by noise when holding the accumulated charge of the photoelectric conversion element.

In consideration thereof, the present disclosure provides a light detection device and an electronic apparatus that can achieve higher resolution and improve image quality of captured images.

### [Solution to Problem]

In order to solve the problem described above, the present disclosure provides a light detection device including: a plurality of pixels each having a photoelectric conversion element configured to accumulate an electric charge in accordance with an amount of incident light; a plurality of first pixel circuits configured to hold, at a same timing, voltage signals in accordance with an electric charge accumulated in the plurality of pixels; a plurality of second pixel circuits that are shared by each of two or more first pixel circuits among the plurality of first pixel circuits and configured to sequentially read the voltage signals held by the two or more first pixel circuits and to generate a pixel signal; and a logic circuit configured to perform signal processing of a plurality of the pixel signals generated by the plurality of second pixel circuits, wherein each of the plurality of first pixel circuits includes:
a first capacitative element configured to hold a voltage signal output from a corresponding pixel in a state where an electric charge of a first floating diffusion region of the pixel has been initialized;
a second capacitative element configured to hold a voltage signal output from the corresponding pixel in a state where an accumulated charge of the photoelectric conversion element has been transferred to the first floating diffusion region of the pixel;
a first transistor configured to switch between whether or not to transfer an electric charge held in the first capacitative element to a second floating diffusion region shared by the two or more first pixel circuits; and
a second transistor configured to switch between whether or not to transfer an electric charge held in the second capacitative element to the second floating diffusion region,
each of the plurality of second pixel circuits includes a source follower circuit having a third transistor configured to generate a pixel signal in accordance with an electric charge of the second floating diffusion region, and
two or more of the first transistors and two or more of the second transistors included in the two or more first pixel circuits are arranged in point symmetry or line symmetry around the one third transistor.

For each of the two or more pixels, a unit pixel group region that has two or more of the first pixel circuits and one of the second pixel circuits may be provided, and the unit pixel group region may have the third transistor and the two or more first transistors and the two or more second transistors that are arranged in point symmetry or line symmetry relative to the third transistor.

The third transistor may be arranged in a central part of the unit pixel group region, and each gate of the two or more first transistors and the two or more second transistors may be arranged at an equal distance from a gate of the third transistor.

A gate length direction of the third transistor arranged in the unit pixel group region and gate length directions of the two or more first transistors and the two or more second transistors may be parallel to each other.

A gate length direction of the third transistor arranged in the unit pixel group region, and gate length directions of the two or more first transistors and the two or more second transistors may intersect with each other.

The unit pixel group region may be a rectangular region arranged in a first direction and a second direction that intersects with the first direction,
the unit pixel group region may include:
a first region in which the two or more first transistors and the two or more second transistors are arranged on a single axis along the first direction; and
a second region which is arranged separated from the first region in the second direction and in which the two or more first transistors and the two or more second transistors are arranged on a single axis along the first direction,
the third transistor may be arranged between the first region and the second region that are arranged separated from each other in the second direction, and
the gate length directions of the first transistors, the second transistors, and the third transistor may be the first direction.

Each of the plurality of second pixel circuits may include:
a fourth transistor configured to output the pixel signal to a signal line; and
a fifth transistor configured to switch between whether or not to initialize an electric charge in the second floating diffusion region,
the unit pixel group region may include
a third region in which the fourth transistor, the third transistor, and the fifth transistor are arranged on a single axis along the first direction, and
the third region may be arranged between the first region and the second region that are arranged separated from each other in the second direction.

Each of the plurality of first pixel circuits may include a sixth transistor and a seventh transistor configured to precharge the first capacitative element and the second capacitative element, the unit pixel group region may include:
a fourth region in which two or more of the sixth transistors and two or more of the seventh transistors are arranged on a single axis along the first direction; and
a fifth region which is arranged separated from the fourth region in the second direction and in which two or more of the sixth transistors and two or more of the seventh transistors are arranged on a single axis along the first direction, and
the fourth region may be arranged between the fourth region and the fifth region that are arranged separated from each other in the second direction.

The unit pixel group region may be a rectangular region arranged in a first direction and a second direction that intersects with the first direction, the unit pixel group region may include:
a first region in which the two or more first transistors and the two or more second transistors are arranged on a single axis along the second direction; and
a second region which is arranged separated from the first region in the first direction and
in which the two or more first transistors and the two or more second transistors are arranged on a single axis along the second direction,
the third transistor may be arranged between the first region and the second region that are arranged separated from each other in the first direction,
channels of the first transistors and the second transistors may be extended in the second direction, and
a channel of the third transistor may be extended in the first direction.

A diffusion layer of the third transistor may be arranged on both sides in the second direction across a channel of the third transistor.

Each of the plurality of second pixel circuits may include:
a fourth transistor configured to output the pixel signal to a signal line; and
a fifth transistor configured to switch between whether or not to initialize an electric charge in the second floating diffusion region,
the unit pixel group region may be a rectangular region arranged in a first direction and a second direction that intersects with the first direction,
the unit pixel group region may include:
   a first region in which the two or more first transistors and the two or more second transistors are arranged on a single axis along the second direction;
   a second region which is arranged separated from the first region in the first direction and in which the two or more first transistors and the two or more second transistors are arranged on a single axis along the first direction; and
   a third region in which the fourth transistor, the third transistor, and the fifth transistor are arranged along the first direction, and
   the third region may be arranged so as to divide the first region and the second region, which are arranged separated from each other in the first direction, in a central part of the unit pixel group region in the second direction.

Each of the plurality of first pixel circuits may include a sixth transistor and a seventh transistor configured to precharge the first capacitative element and the second capacitative element,
each of the plurality of second pixel circuits may include:
a fourth transistor configured to output the pixel signal to a signal line; and
a fifth transistor configured to switch between whether or not to initialize an electric charge in the second floating diffusion region,
the unit pixel group region may be a rectangular region arranged in a first direction and a second direction that intersects with the first direction,
the unit pixel group region may include:
   a first region in which the two or more first transistors and the two or more second transistors are arranged on a single axis along the second direction;
   a second region which is arranged separated from the first region in the first direction and in which the two or more first transistors and the two or more second transistors are arranged on a single axis along the first direction;
   a third region in which the fourth transistor, the third transistor, and the fifth transistor are arranged along the first direction;
   a fourth region in which two or more of the sixth transistors and two or more of the seventh transistors are arranged along the first direction; and
   a fifth region which is arranged separated from the fourth region in the second direction and in which two or more of the sixth transistors and two or more of the seventh transistors are arranged along the first direction, and
   the third region may be arranged between the fourth region and the fifth region that are arranged separated from each other in the second direction.

A size of the third transistor may be larger than sizes of the first transistors and the second transistors.

The unit pixel group region may have a plurality of the third transistors arranged in a central part and the two or more first transistors and the two or more second transistors that are arranged in point symmetry or line symmetry relative to the plurality of third transistors.

The unit pixel group region may include two of the first pixel circuits in each of the first direction and the second direction and may include one of the second pixel circuits, and the unit pixel group region may have two of the first transistors and two of the second transistors that are arranged in point symmetry or line symmetry relative to the third transistors in the central part.

The unit pixel group region may include one of the first pixel circuits in the first direction, two of the first pixel circuits in the second direction, and one of the second pixel circuits, and
a region in which two of the unit pixel group regions are lined up in the first direction may have two of the first transistors and two of the second transistors that are arranged in point symmetry or line symmetry relative to two of the third transistors in the central part.

A first substrate on which the plurality of pixels are arranged, and
a second substrate which is laminated on the first substrate and on which the plurality of first pixel circuits, the plurality of second pixel circuits, and the logic circuit are arranged may be provided.

A first substrate on which the plurality of pixels are arranged,
a second substrate which is laminated on the first substrate and on which the plurality of first pixel circuits and the plurality of second pixel circuits are arranged, and
a third substrate which is laminated on the second substrate and on which the logic circuit is arranged may be provided, wherein
the first substrate may have a plurality of first metal pads which are arranged so as to oppose the second substrate and to which output nodes of the plurality of pixels are connected,
the second substrate may have:
   a semiconductor layer arranged so as to oppose the third substrate,
   a plurality of second metal pads to be joined to the plurality of first metal pads,
   a plurality of first vias arranged so as to penetrate the semiconductor layer from the plurality of second pixel circuits, and
   a plurality of third metal pads that are arranged so as to oppose the third substrate and to be connected to the plurality of first vias,
   the third substrate may have a plurality of fourth metal pads to be joined to the plurality of third metal pads, and
   each of the plurality of first vias may be arranged for each of the two or more pixels.

Each of the plurality of pixels may have:
a third capacitative element configured to accumulate a part of an accumulated charge of the photoelectric conversion element;
an eighth transistor configured to switch between whether or not to accumulate, to the third capacitative element, a part of an accumulated charge of the photoelectric conversion element ; and
a ninth transistor configured to switch between whether or not to discard an accumulated charge of the photoelectric conversion element.

The present disclosure provides an electronic apparatus including: a light detection device configured to generate an image in accordance with an amount of incident light; and a processing portion configured to process the image, wherein
the light detection device includes:
a plurality of pixels each having a photoelectric conversion element configured to accumulate an electric charge in accordance with an amount of incident light;
a plurality of first pixel circuits configured to hold, at a same timing, voltage signals in accordance with an electric charge accumulated in the plurality of pixels ;
a plurality of second pixel circuits that are shared by each of two or more first pixel circuits among the plurality of first pixel circuits and configured to sequentially read the voltage signals held by the two or more first pixel circuits and to generate a pixel signal; and
a logic circuit configured to perform signal processing of a plurality of the pixel signals generated by the plurality of second pixel circuits, wherein
each of the plurality of first pixel circuits includes:
   a first capacitative element configured to hold a voltage signal output from a corresponding pixel in a state where an electric charge of a first floating diffusion region of the pixel has been initialized;
   a second capacitative element configured to hold a voltage signal output from the corresponding pixel in a state where an accumulated charge of the photoelectric conversion element has been transferred to the first floating diffusion region of the pixel;
   a first transistor configured to switch between whether or not to transfer an electric charge held in the first capacitative element to a second floating diffusion region shared by the two or more first pixel circuits; and
   a second transistor configured to switch between whether or not to transfer an electric charge held in the second capacitative element to the second floating diffusion region,
   each of the plurality of second pixel circuits includes a source follower circuit having a third transistor configured to generate a pixel signal in accordance with an electric charge of the second floating diffusion region, and
   two or more of the first transistors and two or more of the second transistors included in the two or more first pixel circuits are arranged in point symmetry or line symmetry around the one third transistor.

### [Brief Description of Drawings]

[Fig. 1]

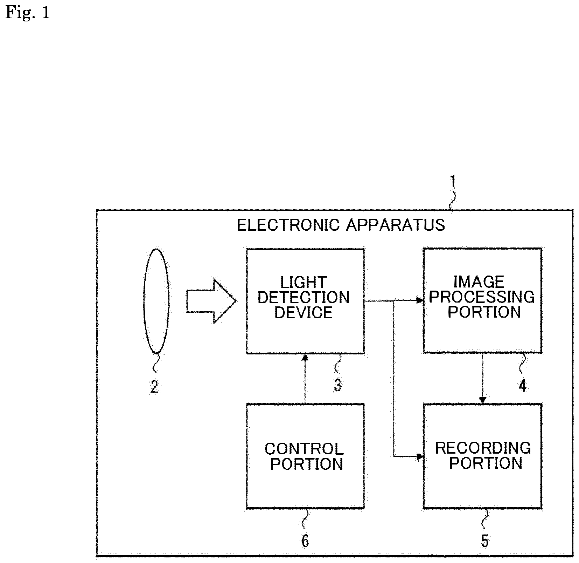

   Fig. 1 is a block diagram of an electronic apparatus according to a first embodiment of the present disclosure.
[Fig. 2]

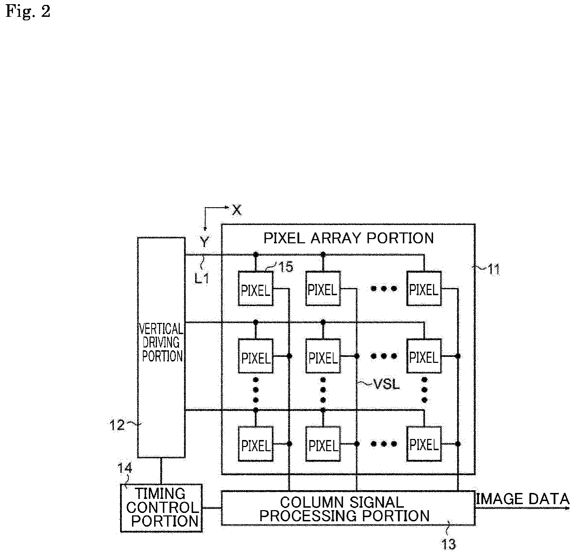

   Fig. 2 is a block diagram showing a schematic configuration of a light detection device according to an embodiment.
[Fig. 3]

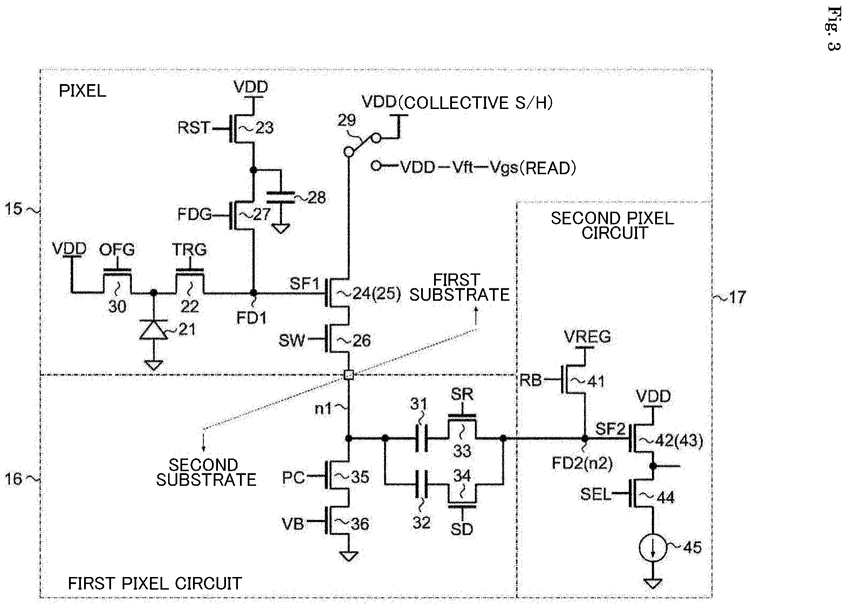

   Fig. 3 is a circuit diagram of a pixel and pixel circuits in a pixel array portion.
[Fig. 4]

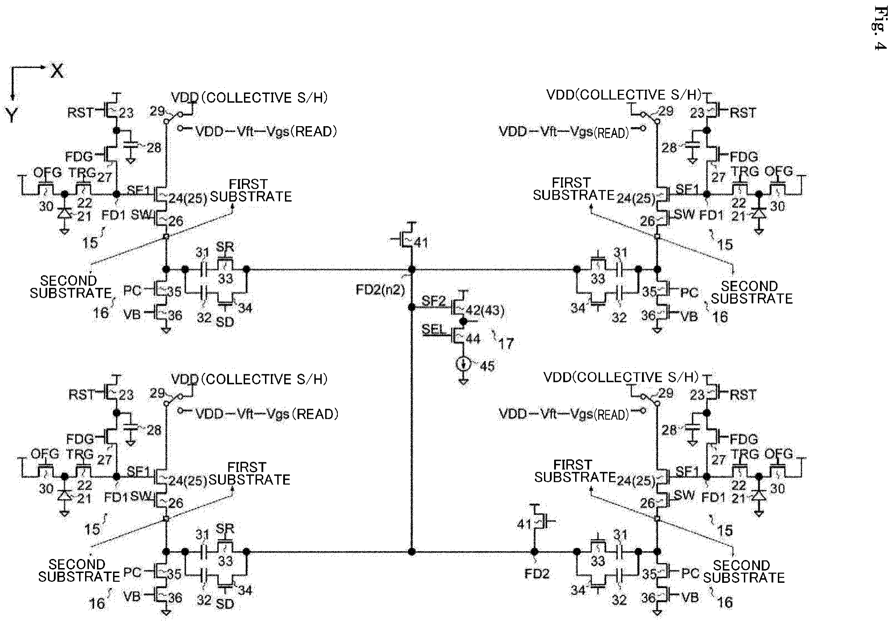

   Fig. 4 is a circuit diagram showing an example in which four pixels and four first pixel circuits share one second pixel circuit.
[Fig. 5]

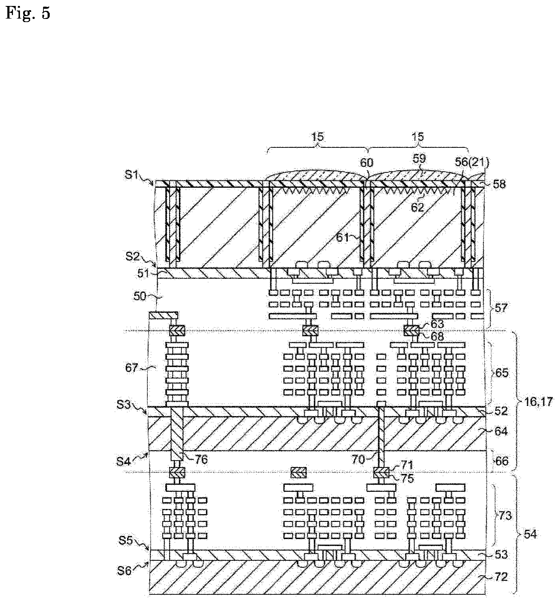

   Fig. 5 is a sectional view showing a cross-sectional structure of the light detection device according to an embodiment.
[Fig. 6]

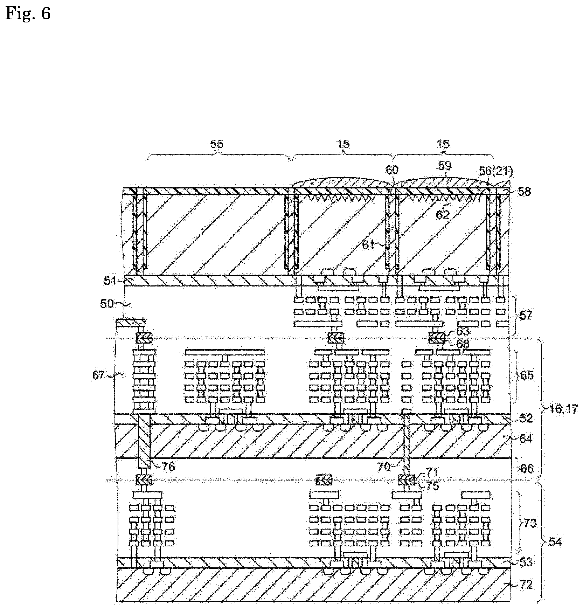

   Fig. 6 is a sectional view showing a first example of a cross-sectional structure of a peripheral circuit of a pixel.
[Fig. 7]

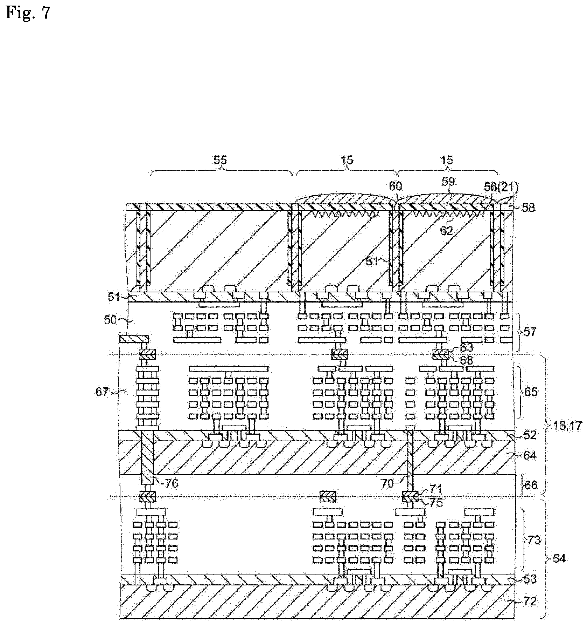

   Fig. 7 is a sectional view showing a second example of a cross-sectional structure of a peripheral circuit of a pixel.
[Fig. 8]

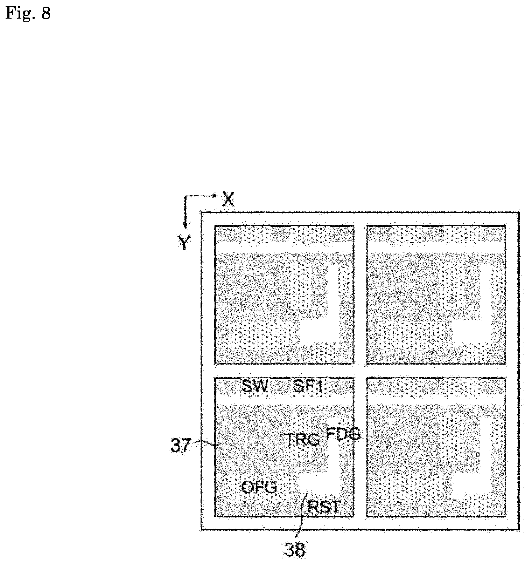

   Fig. 8 is a plan layout view for 2 × 2 pixels of a first substrate when four pixels and four first pixel circuits share one second pixel circuit.
[Fig. 9]

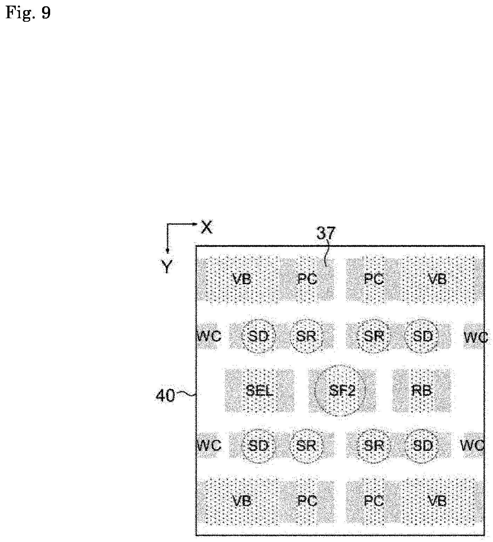

   Fig. 9 is a plan layout view of a unit pixel group region for 2 × 2 pixels of a second substrate that is laminated on the first substrate shown in Fig. 8.
[Fig. 10]

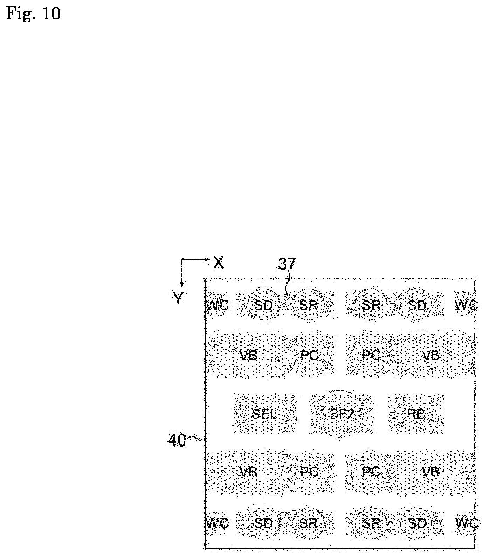

   Fig. 10 is a plan layout view of a second substrate according to a first modification of Fig. 9.
[Fig. 11]

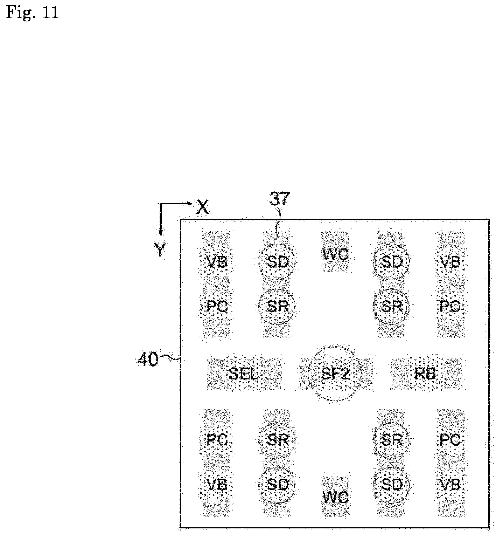

   Fig. 11 is a plan layout view of a second substrate according to a second modification of Fig. 9.
[Fig. 12]

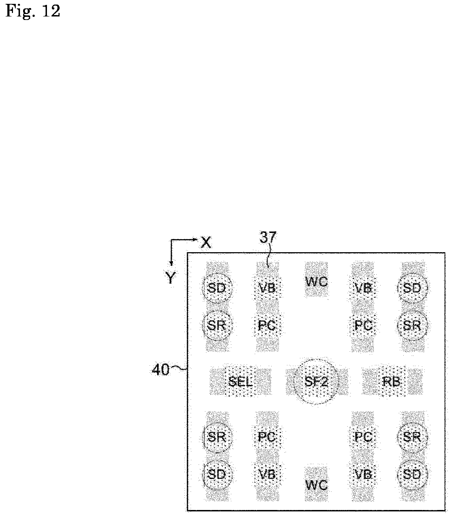

   Fig. 12 is a plan layout view of a second substrate according to a third modification of Fig. 9.
[Fig. 13]

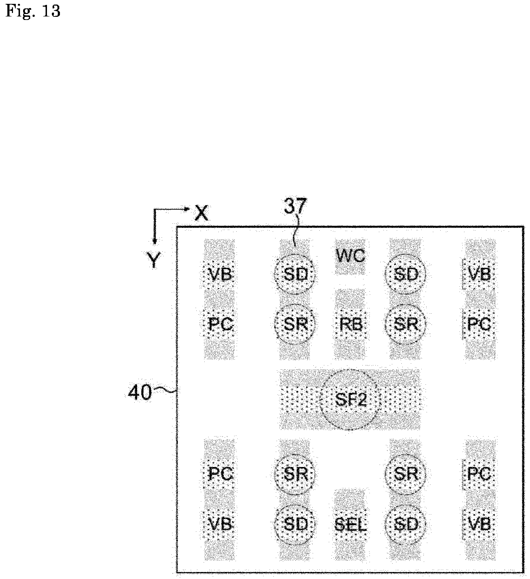

   Fig. 13 is a plan layout view of a second substrate according to a fourth modification of Fig. 9.
[Fig. 14]

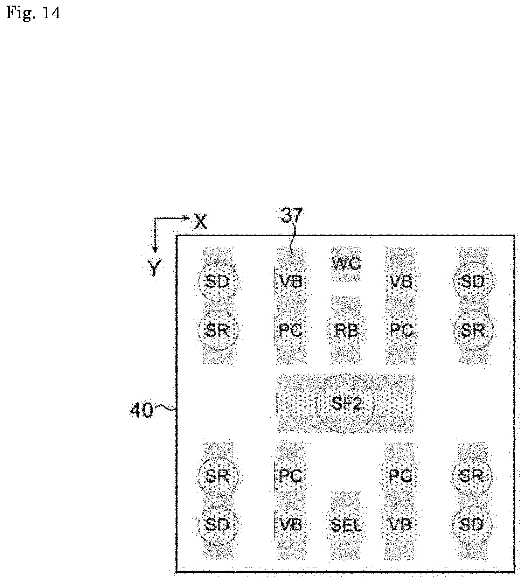

   Fig. 14 is a plan layout view of a second substrate according to a fifth modification of Fig. 9.
[Fig. 15]

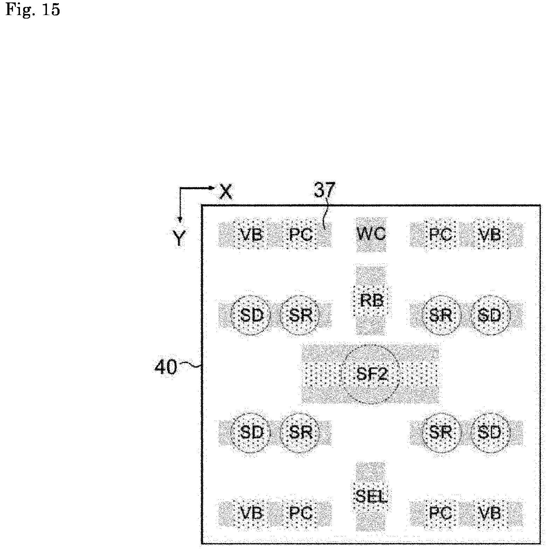

   Fig. 15 is a plan layout view of a second substrate according to a sixth modification of Fig. 9.
[Fig. 16]

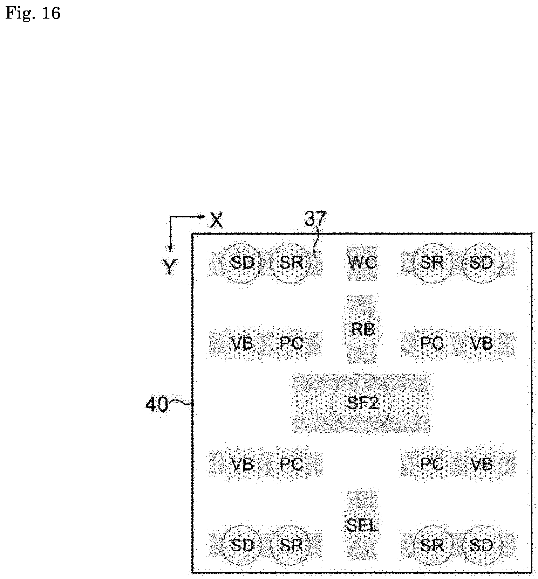

   Fig. 16 is a plan layout view of a second substrate according to a seventh modification of Fig. 9.
[Fig. 17]

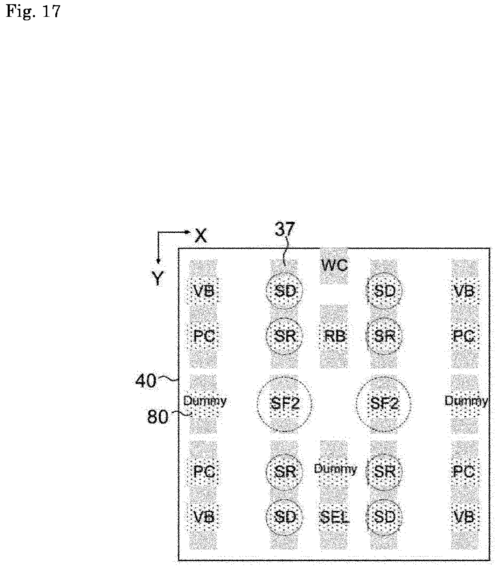

   Fig. 17 is a plan layout view of a second substrate according to an eighth modification of Fig. 9.
[Fig. 18]

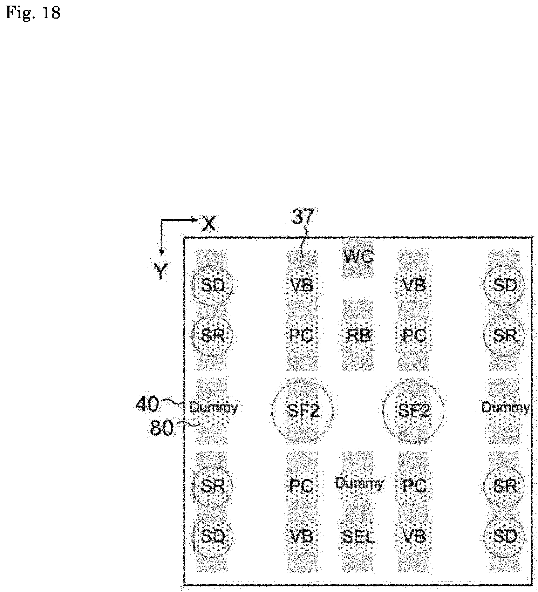

   Fig. 18 is a plan layout view of a second substrate according to a ninth modification of Fig. 9.
[Fig. 19]

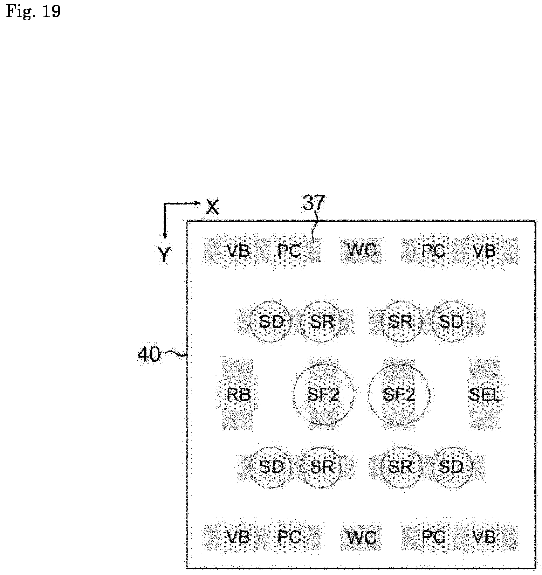

   Fig. 19 is a plan layout view of a second substrate according to a tenth modification of Fig. 9.
[Fig. 20]

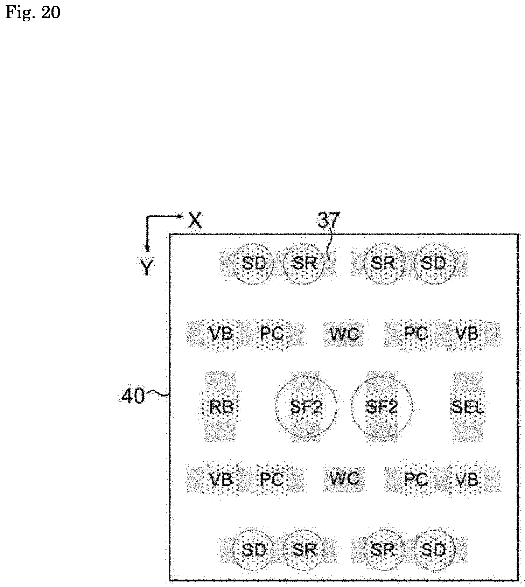

   Fig. 20 is a plan layout view of a second substrate according to an eleventh modification of Fig. 9.
[Fig. 21]

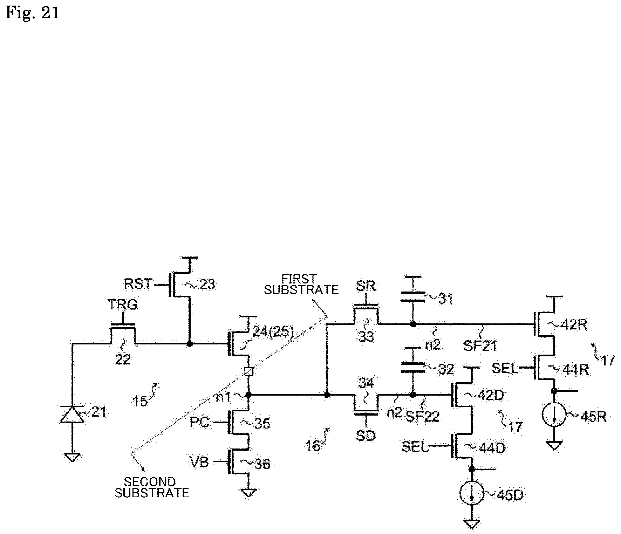

   Fig. 21 is a circuit diagram of a pixel and pixel circuits according to a modification of Fig. 3.
[Fig. 22]

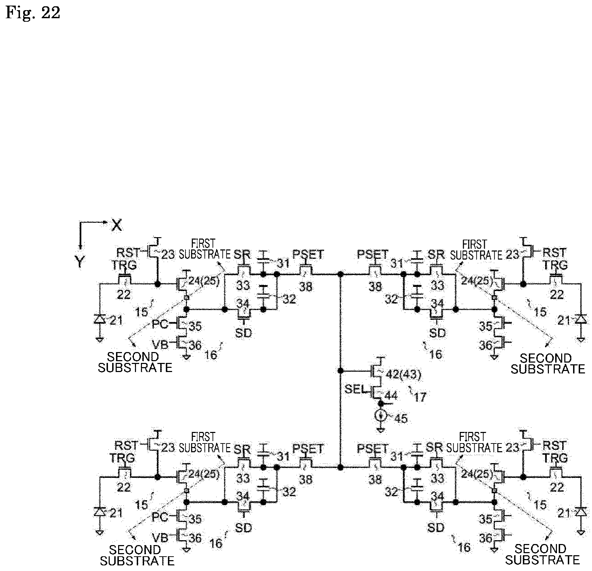

   Fig. 22 is a circuit diagram in a case where four pixels and four first pixel share one second pixel circuit according to a circuit configuration shown in Fig. 21.
[Fig. 23]

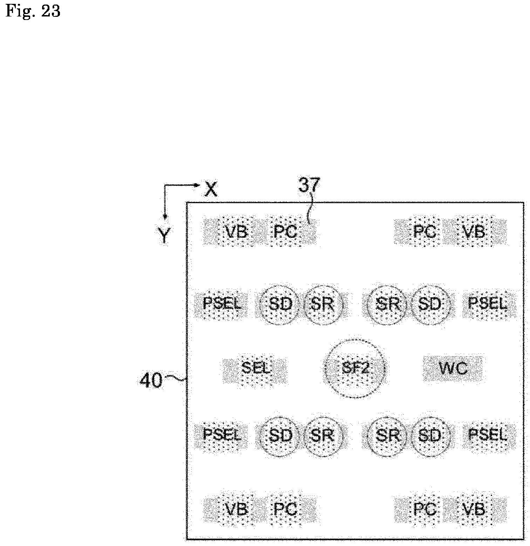

   Fig. 23 is a plan layout view of a unit pixel group region for 4 × 4 pixels of a second substrate that is constituted of the pixel and the pixel circuits shown in Fig. 22.
[Fig. 24]

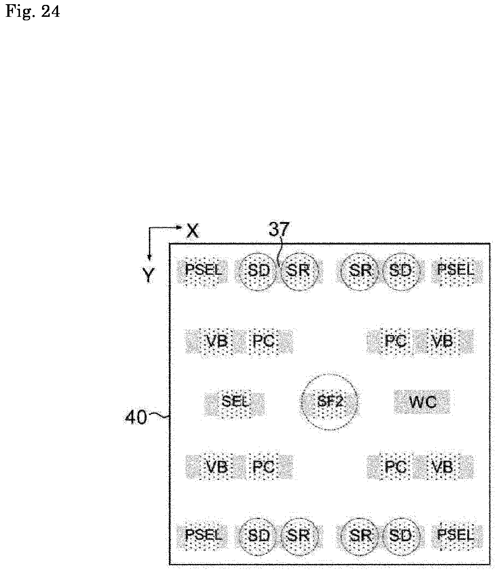

   Fig. 24 is a plan layout view of a second substrate according to a first modification of Fig. 23.
[Fig. 25]

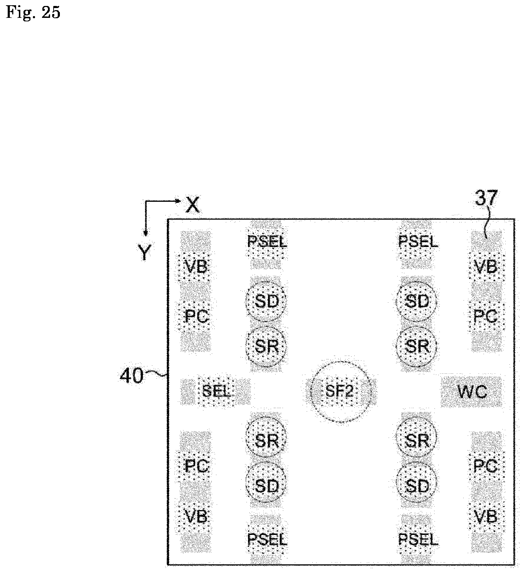

   Fig. 25 is a plan layout view of a second substrate according to a second modification of Fig. 23.
[Fig. 26]

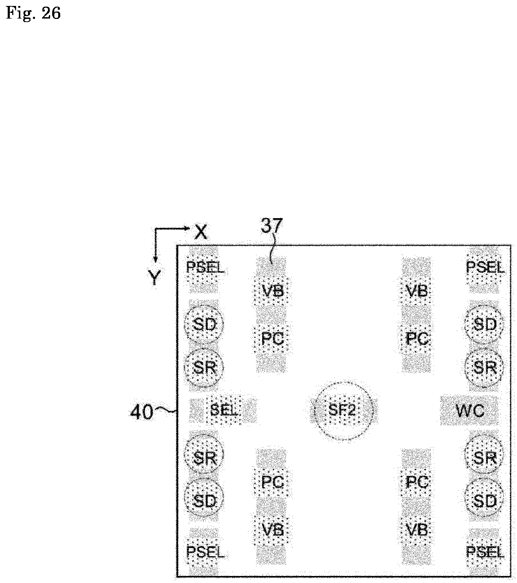

   Fig. 26 is a plan layout view of a second substrate according to a third modification of Fig. 23.
[Fig. 27]

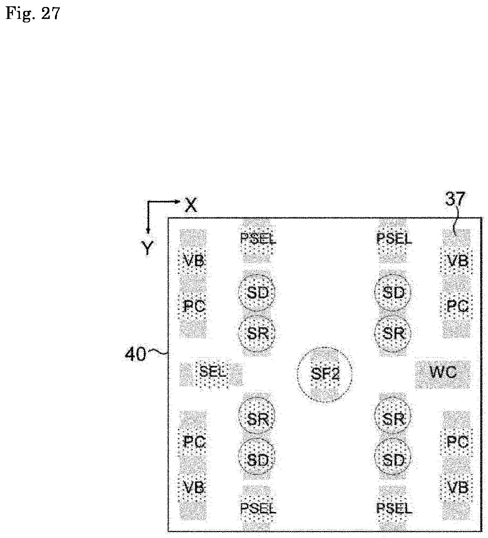

   Fig. 27 is a plan layout view of a second substrate according to a fourth modification of Fig. 23.
[Fig. 28]

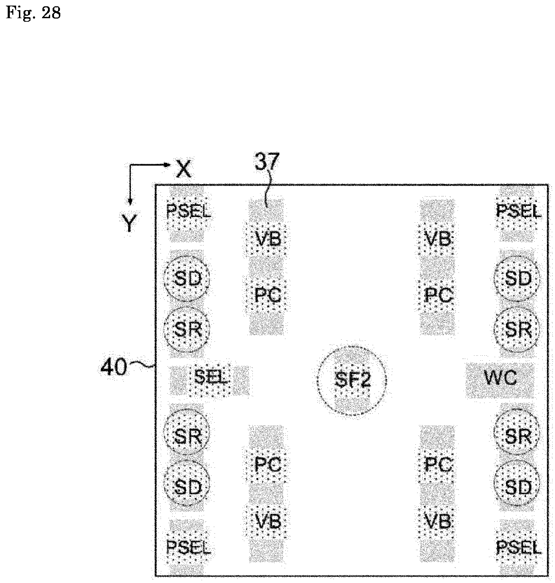

   Fig. 28 is a plan layout view of a second substrate according to a fifth modification of Fig. 23.
[Fig. 29]

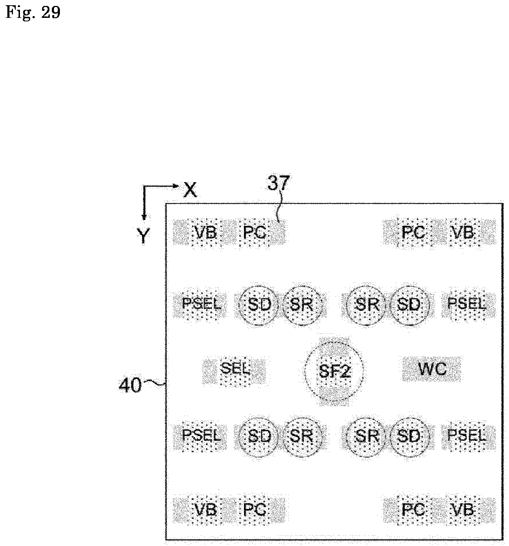

   Fig. 29 is a plan layout view of a second substrate according to a sixth modification of Fig. 23.
[Fig. 30]

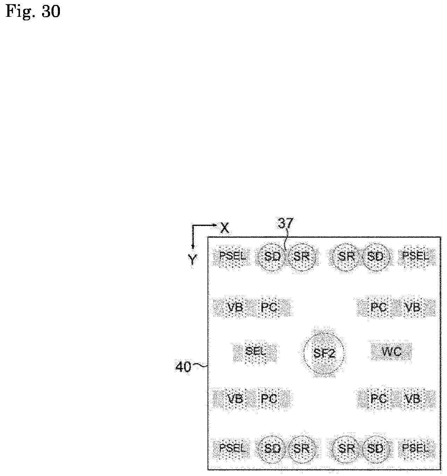

   Fig. 30 is a plan layout view of a second substrate according to a seventh modification of Fig. 23.
[Fig. 31]

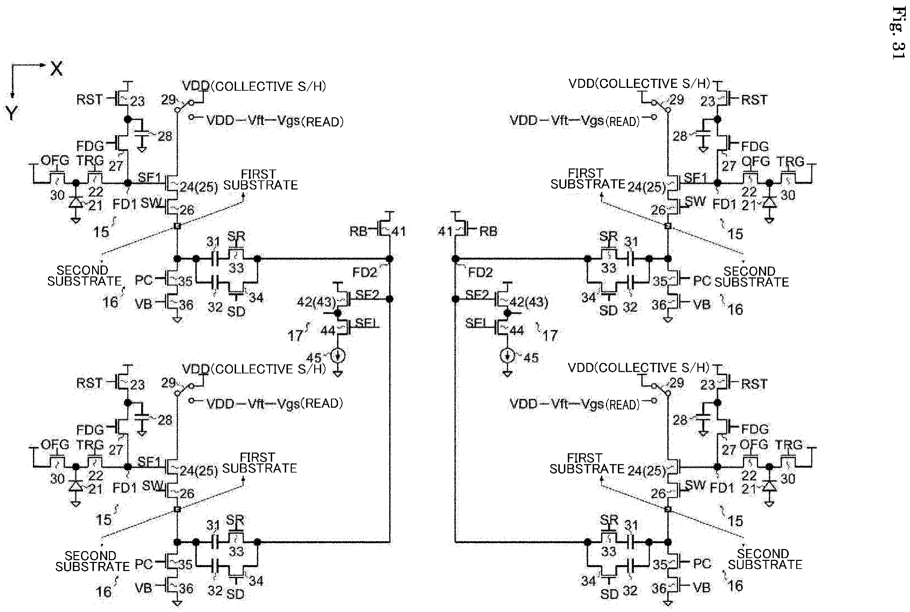

   Fig. 31 is a circuit diagram in a case where two pixels and two first pixel circuits share one second pixel circuit using the pixel, the first pixel circuit, and the second pixel circuit according to the circuit configuration shown in Fig. 3.
[Fig. 32]

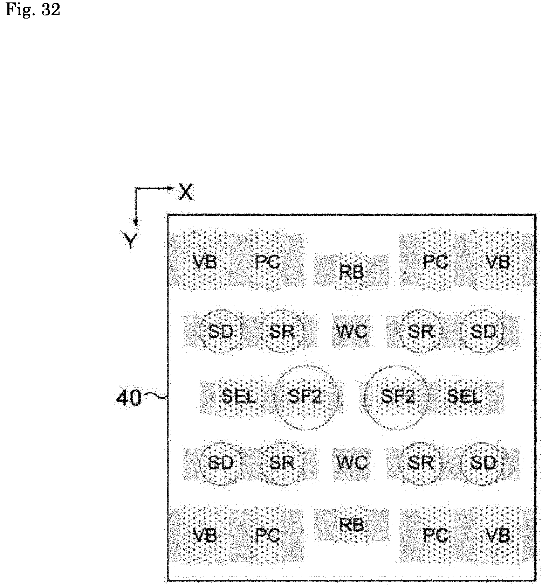

   Fig. 32 is a plan layout view of a region in which two unit pixel group regions for 1 × 2 pixels of a second substrate that is constituted of the pixel and the pixel circuits shown in Fig. 31 are lined up in a first direction X.
[Fig. 33]

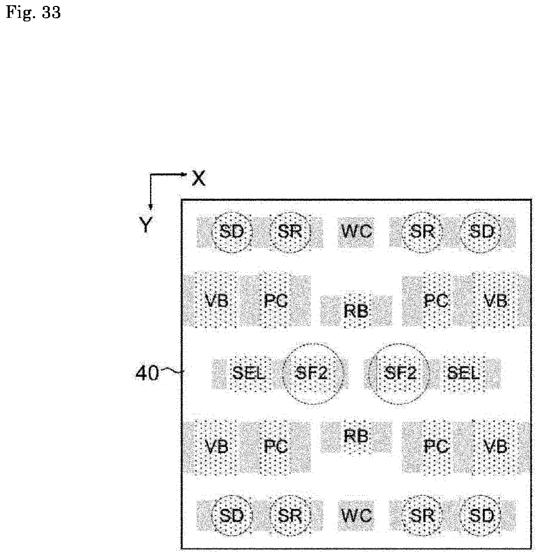

   Fig. 33 is a plan layout view of a second substrate according to a first modification of Fig. 32.
[Fig. 34]

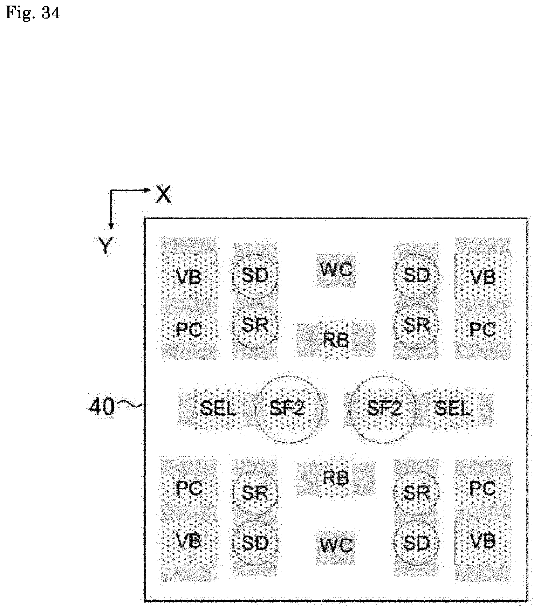

   Fig. 34 is a plan layout view of a second substrate according to a second modification of Fig. 32.
[Fig. 35]

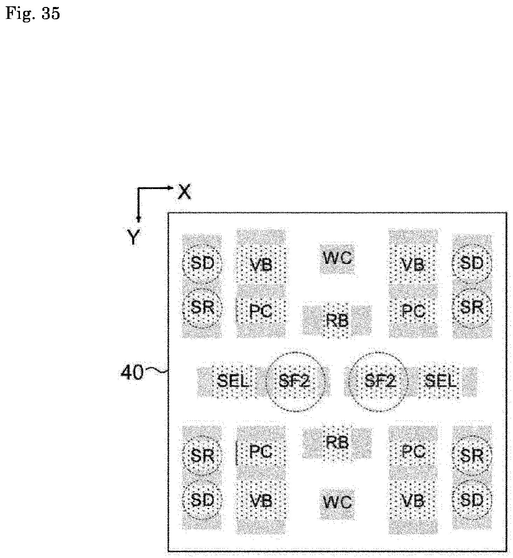

   Fig. 35 is a plan layout view of a second substrate according to a third modification of Fig. 32.
[Fig. 36]

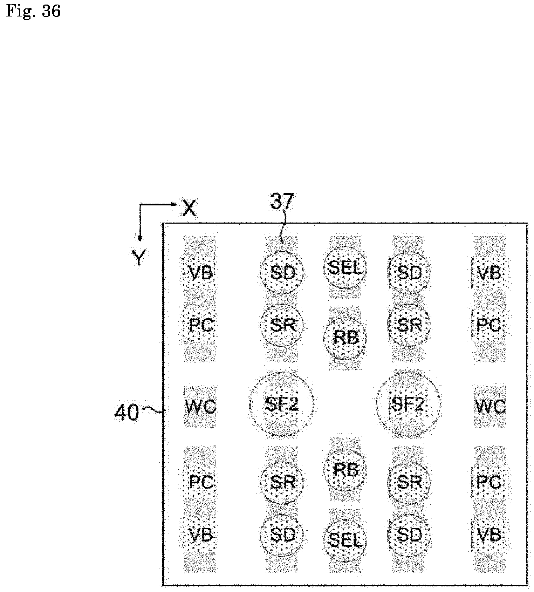

   Fig. 36 is a plan layout view of a second substrate according to a fourth modification of Fig. 32.
[Fig. 37]

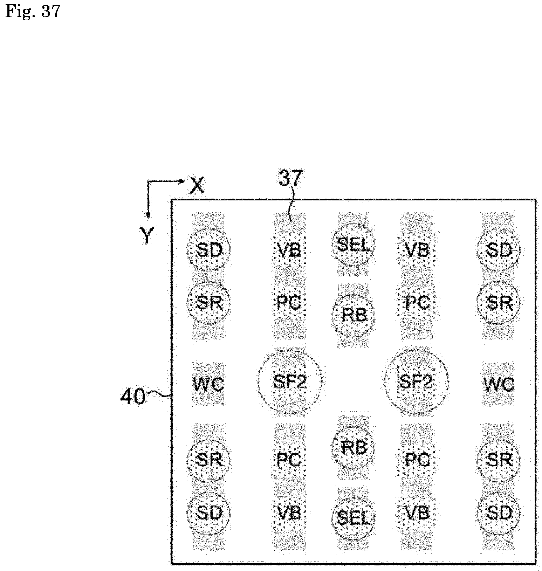

   Fig. 37 is a plan layout view of a second substrate according to a fifth modification of Fig. 32.
[Fig. 38]

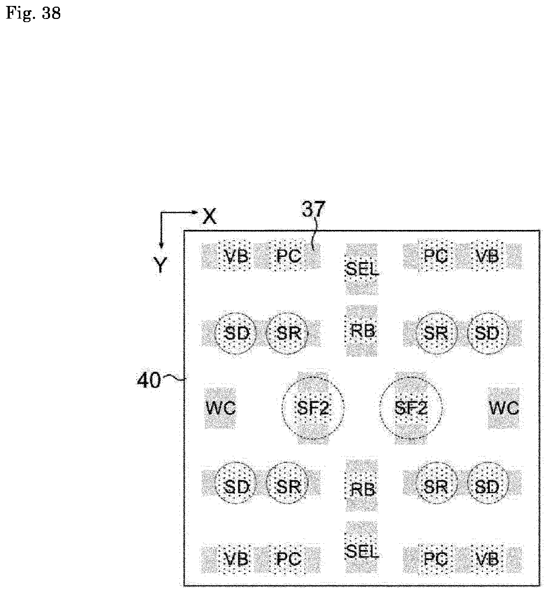

   Fig. 38 is a plan layout view of a second substrate according to a sixth modification of Fig. 32.
[Fig. 39]

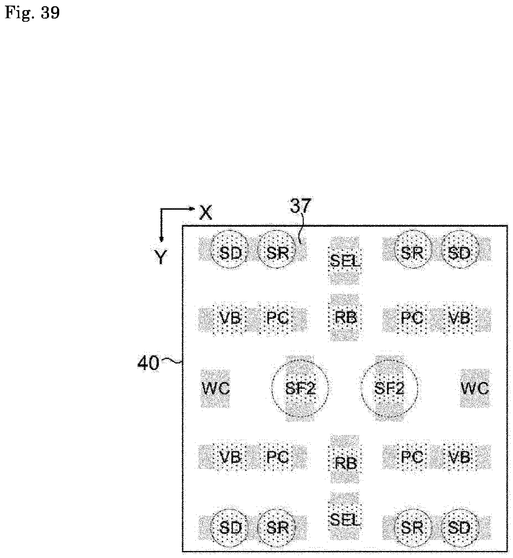

   Fig. 39 is a plan layout view of a second substrate according to a seventh modification of Fig. 32.
[Fig. 40]

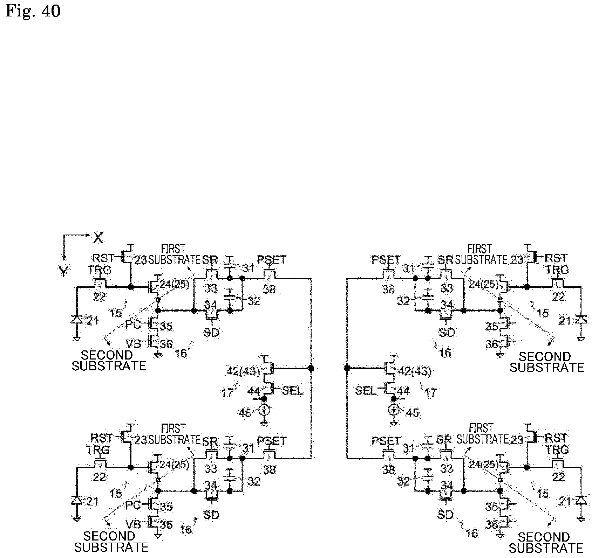

   Fig. 40 is a circuit diagram in a case where two pixels and two first pixel circuits share one second pixel circuit using the pixel, the first pixel circuit, and the second pixel circuit according to the circuit configuration shown in Fig. 21.
[Fig. 41]

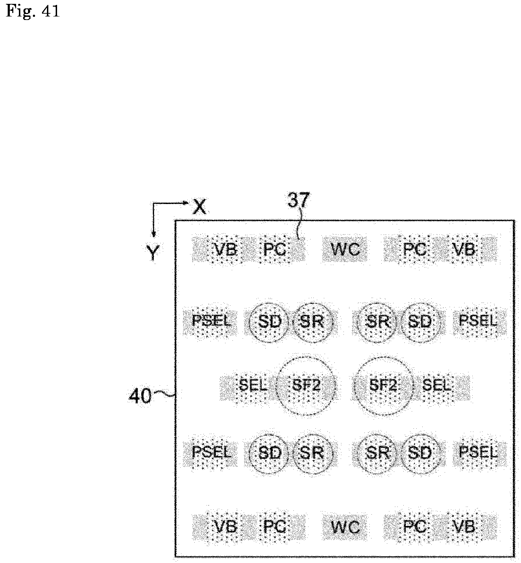

   Fig. 41 is a plan layout view of a region in which two unit pixel group regions for 1 × 2 pixels of a second substrate that is constituted of the pixel and the pixel circuits shown in Fig. 40 are lined up.
[Fig. 42]

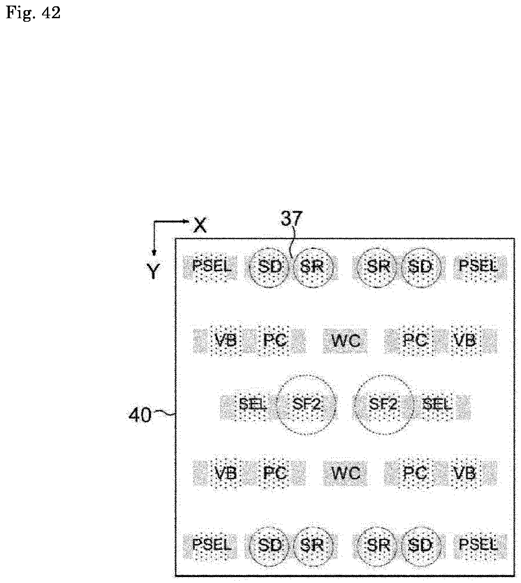

   Fig. 42 is a plan layout view of a second substrate according to a first modification of Fig. 41.
[Fig. 43]

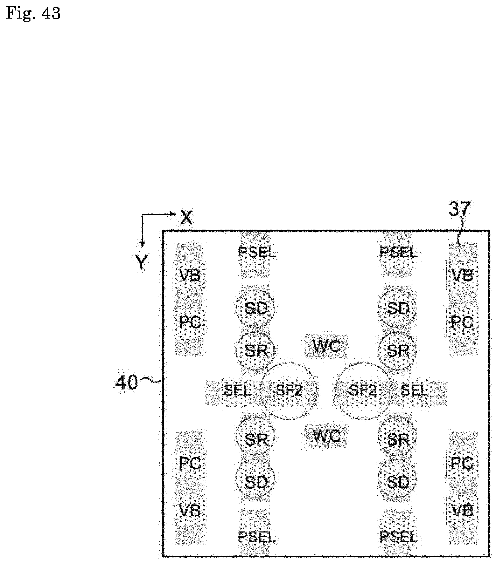

   Fig. 43 is a plan layout view of a second substrate according to a second modification of Fig. 41.
[Fig. 44]

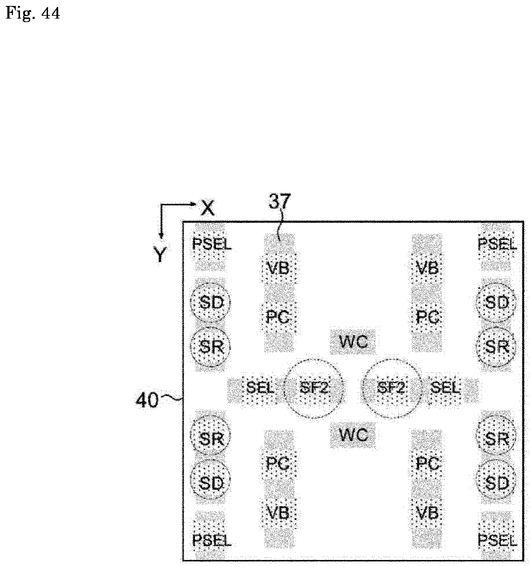

   Fig. 44 is a plan layout view of a second substrate according to a third modification of Fig. 41.
[Fig. 45]

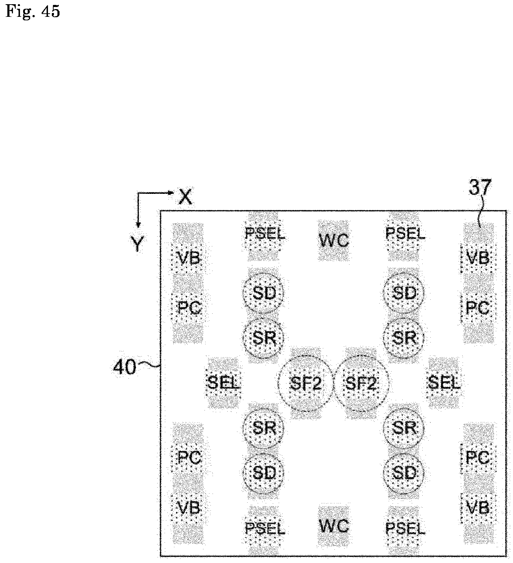

   Fig. 45 is a plan layout view of a second substrate according to a fourth modification of Fig. 41.
[Fig. 46]

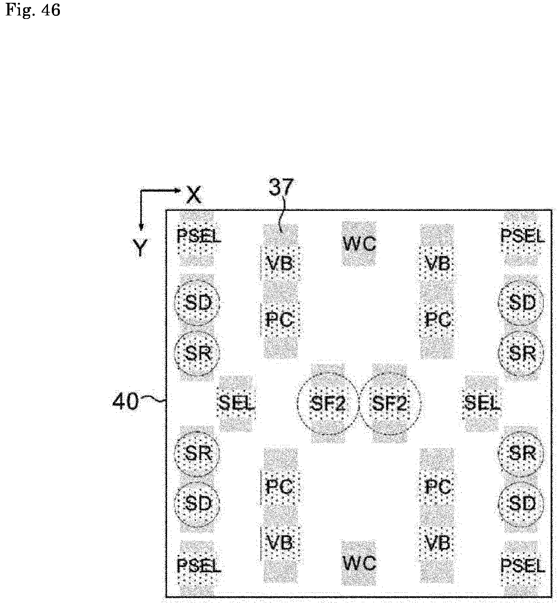

   Fig. 46 is a plan layout view of a second substrate according to a fifth modification of Fig. 41.
[Fig. 47]

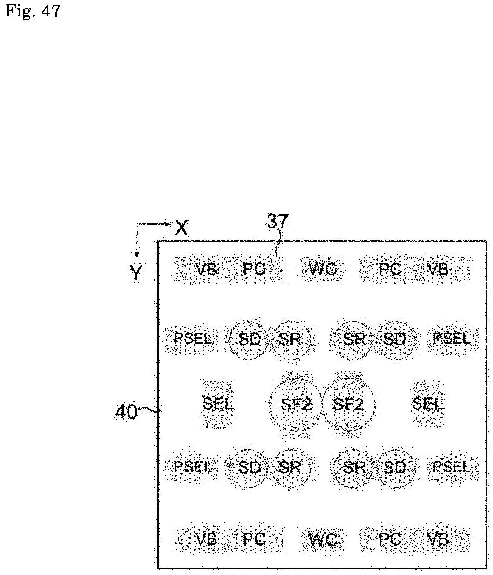

   Fig. 47 is a plan layout view of a second substrate according to a sixth modification of Fig. 41.
[Fig. 48]

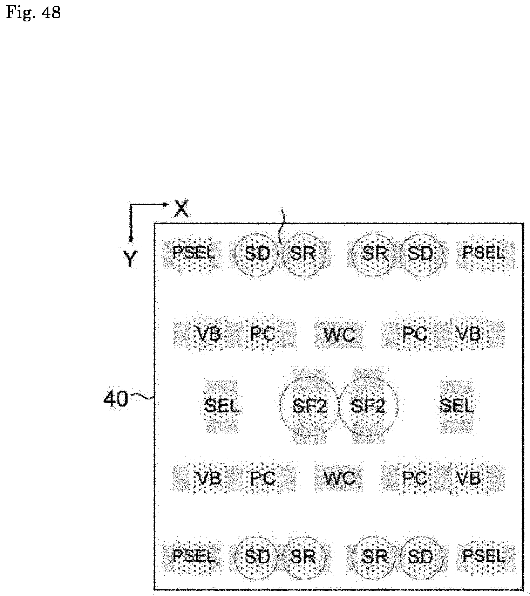

   Fig. 48 is a plan layout view of a second substrate according to a sixth modification of Fig. 41.
[Fig. 49]

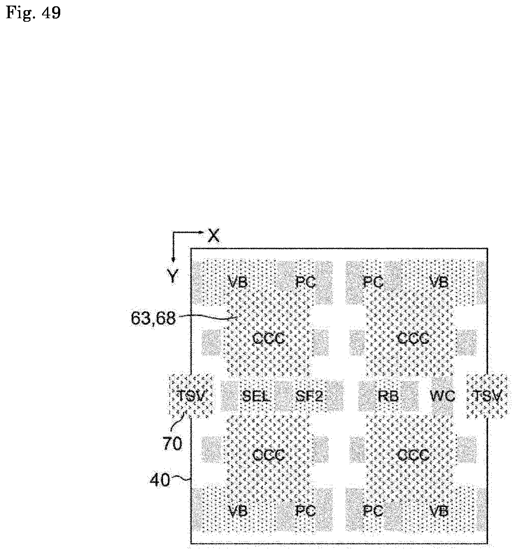

   Fig. 49 is a plan layout view showing an example of a junction location of a first metal pad and a second metal pad and an arrangement location of a TSV on a second substrate.
[Fig. 50]

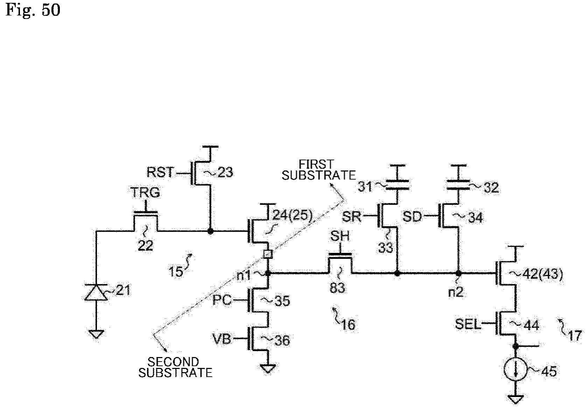

   Fig. 50 is a circuit diagram of a pixel, a first pixel circuit, and a second pixel circuit according to a first modification.
[Fig. 51]

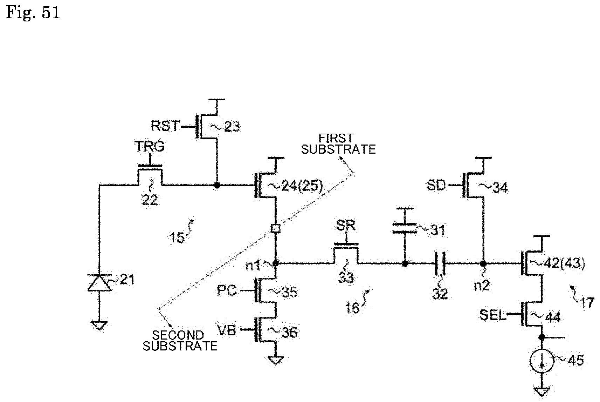

   Fig. 51 is a circuit diagram of a pixel, a first pixel circuit, and a second pixel circuit according to a second modification.
[Fig. 52]

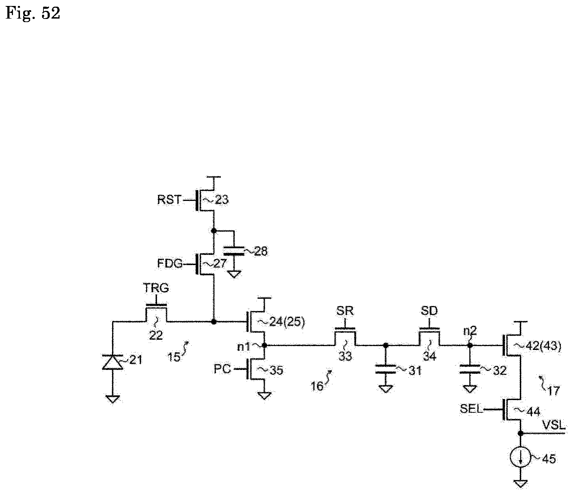

   Fig. 52 is a circuit diagram of a pixel, a first pixel circuit, and a second pixel circuit according to a third modification.
[Fig. 53]

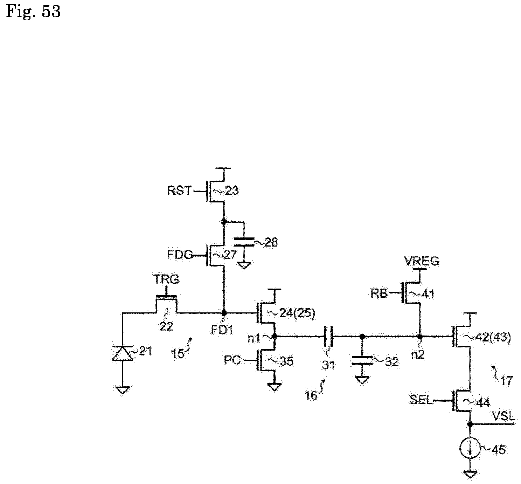

   Fig. 53 is a circuit diagram of a pixel, a first pixel circuit, and a second pixel circuit according to a fourth modification.
[Fig. 54]

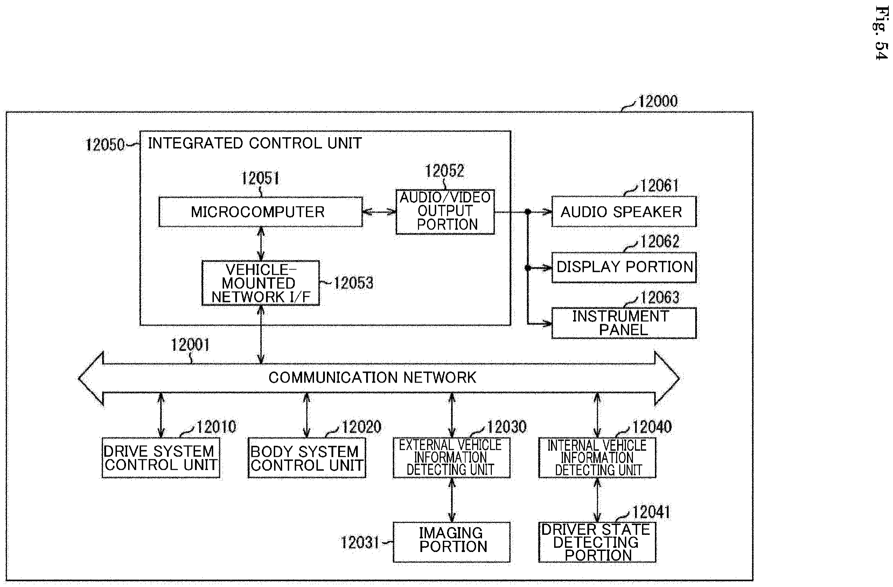

   Fig. 54 is a block diagram showing an example of a schematic configuration of a vehicle control system.
[Fig. 55]

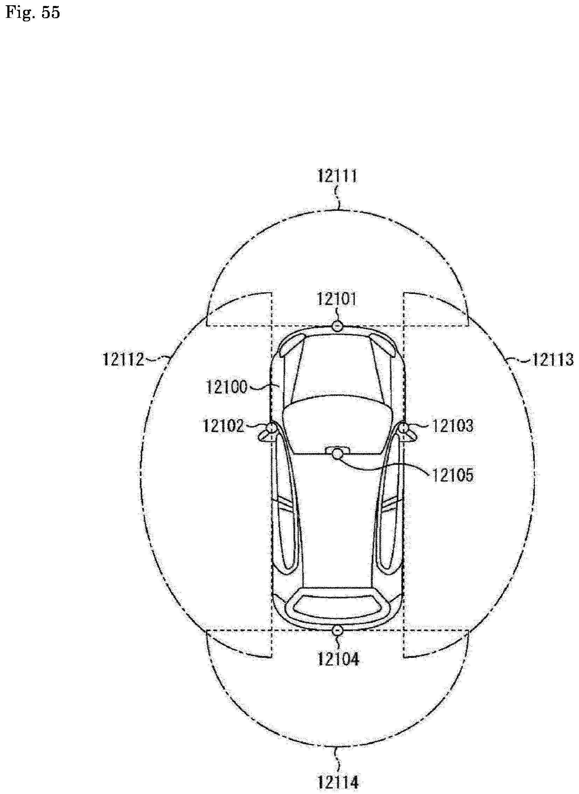

   Fig. 55 is an explanatory diagram showing an example of installation positions of an external vehicle information detecting portion and an imaging portion.
[Fig. 56]

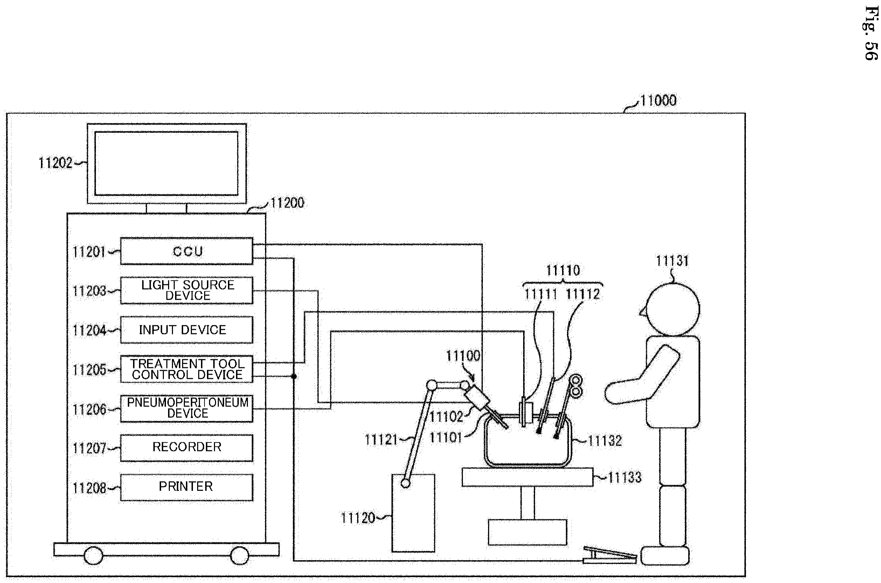

   Fig. 56 is a diagram showing an example of a schematic configuration of an endoscopic surgery system.
[Fig. 57]

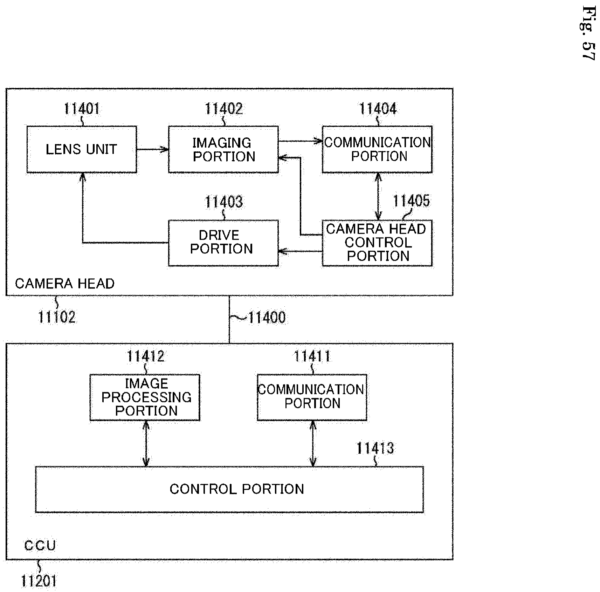

   Fig. 57 is a block diagram showing an example of functional configurations of a camera head and a CCU.

### [Description of Embodiments]

Hereinafter, embodiments of a light detection device and an electronic apparatus will be described with reference to drawings. Although the following description focuses on major components of the light detection device and the electronic apparatus, other components and functions that are not illustrated or described may be present in the light detection device and the electronic apparatus. The following description does not exclude any component or function that is not illustrated or described.

Fig. 1 is a block diagram of an electronic apparatus 1 according to a first embodiment of the present disclosure. The electronic apparatus 1 is equipped with a function to generate images according to a brightness of incident light. The electronic apparatus 1 in Fig. 1 includes an imaging lens 2, a light detection device 3, an image processing portion 4, a recording portion 5, and a control portion 6. While the electronic apparatus 1 can be applied to, for example, a surveillance camera, a camera mounted on an industrial robot, or a camera for general use, a specific application and a specific configuration of the electronic apparatus 1 are arbitrary.

The imaging lens 2 collects incident light and guides the incident light to the light detection device 3. The light detection device 3 captures incident light. The light detection device 3 is equipped with a function to photoelectrically convert light in a predetermined wavelength range such as visible light or infrared light and generate a captured image. The captured image generated by the light detection device 3 is sent to the image processing portion 4 and the recording portion 5.

The image processing portion 4 executes, with respect to a captured image, predetermined image processing such as color or brightness adjustment, image compression, image recognition, tracking, or analysis. An image subjected to image processing by the image processing portion 4 is output to, for example, the recording portion 5.

The recording portion 5 records an image output from the light detection device 3 or the image processing portion 4. The recording portion 5 may be arranged on a server or the like connected via a network. In the electronic apparatus 1 according to the present embodiment, at least one of the image processing portion 4 and the recording portion 5 in Fig. 1 can be omitted.

The control portion 6 controls an operation of the light detection device 3. In addition, although not explicitly shown in Fig. 1, the control portion 6 may control the image processing portion 4 and the recording portion 5.

Fig. 2 is a block diagram showing a schematic configuration of the light detection device 3 according to an embodiment. As shown in Fig. 2, the light detection device 3 according to the embodiment includes a pixel array portion 11, a vertical driving portion 12, a column signal processing portion 13, and a timing control portion 14.

The pixel array portion 11 includes a plurality of pixels 15 arrayed in a first direction (for example, a row direction) X and a second direction (for example, a vertical direction) Y. Although not shown in Fig. 2, a pixel circuit is connected to each pixel 15. Detailed configurations of the pixel 15 and the pixel circuit will be described later.

The vertical driving portion 12 sequentially selects and drives each of a plurality of pixel groups (for example, pixel rows) arrayed in the first direction X of the pixel array portion 11. More specifically, a plurality of row selection lines L1 are connected to the vertical driving portion 12. Each of the plurality of row selection lines L1 is used to drive a corresponding pixel row.

A vertical signal line VSL is connected to each of a plurality of pixel groups (for example, pixel columns) arrayed in the second direction Y of the pixel array portion 11. Each vertical signal line VSL transmits a pixel signal generated by the pixel circuit connected to each pixel 15. The plurality of vertical signal lines VSL are connected to the column signal processing portion 13.

The column signal processing portion 13 subjects a pixel signal transmitted by each vertical signal line VSL to analog-digital conversion and generates a digital pixel signal. The column signal processing portion 13 is controlled by a horizontal driving portion (not illustrated) and sequentially outputs digital pixel signals.

The timing control portion 14 controls timings of the vertical driving portion 12 and the column signal processing portion 13.

As will be described later, the light detection device 3 according to the embodiment is constructed by laminating three semiconductor substrates (referred to as a first substrate, a second substrate, and a third substrate). Each pixel 15 and the pixel circuit of the pixel array portion 11 is arranged so as to be divided between the first substrate and the second substrate. In the present specification, of the pixels 15 and the pixel circuits, while those arranged on the first substrate are called pixels 15 and those arranged on the second substrate are called pixel circuits, a boundary between the pixels 15 and the pixel circuits is not clearly defined and, in the present specification, the pixels 15 and the pixel circuits may be collectively referred to as the pixels 15.

Fig. 3 is a circuit diagram of the pixel 15 and the pixel circuits in the pixel array portion 11. In the present embodiment, a pixel sharing system is adopted in which a part of the pixel circuits connected to the pixel 15 is shared by a plurality of pixels 15. In the present specification, among the pixel circuits, a circuit portion provided for each pixel 15 is referred to as a first pixel circuit 16 and a circuit portion shared by a plurality of pixels 15 is referred to as a second pixel circuit 17.

As shown in Fig. 3, the pixel 15 has a photoelectric conversion element 21, a transfer transistor 22, a first reset transistor 23, a first amplifying transistor 25 that constitutes a first source follower circuit (SF1) 24, and a first selective transistor 26. While Fig. 3 shows an example in which all of the transistors of the pixel 15 and the pixel circuits are constituted of NMOS (N-channel Metal Oxide Semiconductor) transistors, at least a part of the transistors may be constituted of PMOS (P-channel MOS) transistors.

The photoelectric conversion element 21 is, for example, a photodiode. The photoelectric conversion element 21 accumulates an electric charge in accordance with an amount of incident light.

The photoelectric conversion elements 21 of all of the pixels 15 start exposure at a same timing. The transfer transistors 22 of all of the pixels 15 transfer an accumulated charge in the photoelectric conversion element 21 to a first floating diffusion region FD1. The first floating diffusion region FD1 is set to a reset state where an electric charge has been discharged or a state where the accumulated charge in the photoelectric conversion element 21 or, in other words, a signal charge has been transferred. The transfer transistor 22 turns on when a TRG signal is at a high level. As described above, the TRG signals of all of the pixels 15 transition to a high level at a same timing.

The first reset transistor 23 discharges the accumulated charge in the photoelectric conversion element 21 and the electric charge in the first floating diffusion region FD1 before the photoelectric conversion element 21 starts a photoelectric conversion operation (hereinafter, sometimes also referred to as an exposure operation). The first reset transistor 23 turns on when an RST signal is at a high level.

While a conversion efficiency switching transistor 27 and an electric charge holding portion 28 are arranged between the first reset transistor 23 and the first floating diffusion region FD1 in Fig. 3, the conversion efficiency switching transistor 27 and the electric charge holding portion 28 can be omitted. The electric charge holding portion 28 is connected between a drain of the conversion efficiency switching transistor 27 and a reference voltage node (for example, a ground voltage node). Holding a part of the accumulated charge in the photoelectric conversion element 21 with the electric charge holding portion 28 via the conversion efficiency switching transistor 27 enables a larger accumulated charge to be held and a dynamic range to be expanded. The conversion efficiency switching transistor 27 turns on when an FDG signal is at a high level and causes the electric charge holding portion 28 to hold the accumulated charge in the photoelectric conversion element 21.

The first amplifying transistor 25 that constitutes the first source follower circuit 24 generates a voltage signal in accordance with an accumulated charge in the first floating diffusion region FD1. When the first selective transistor 26 is turned on, the voltage signal is sent to the first pixel circuit 16.

A drain of the first amplifying transistor 25 may be connected to a power supply voltage node or to a voltage switcher 29 as shown in Fig. 3. The voltage switcher 29 switches and connects the drain of the first amplifying transistor 25 to a first reference voltage node or a second reference voltage node. The voltage switcher 29 selects the first reference voltage node when a voltage signal corresponding to an accumulated charge or a reset electric charge due to photoelectric conversion is held in a first capacitative element or a second capacitative element to be described later and selects the second reference voltage node when a pixel signal is read out from the second pixel circuit 17 to the vertical signal line VSL. The first reference voltage node has a higher voltage level than the second reference voltage node.

The first selective transistor 26 turns on when an SW signal is at a high level. When the first selective transistor 26 is turned on, a voltage signal of the first floating diffusion region FD1 is sent to the first pixel circuit 16. In the present specification, a source of the first selective transistor is referred to as an output node n1 of the pixel 15.

The pixel 15 may be equipped with a discharge transistor 30. The discharge transistor 30 turns on when an OFG signal is at a high level and discharges an electric charge overflowing from the photoelectric conversion element 21.

As shown in Fig. 3, the first pixel circuit 16 has a first capacitative element 31, a second capacitative element 32, a first sampling transistor 33, and a second sampling transistor 34.

The first capacitative element 31 and the first sampling transistor 33 are connected in series between the output node n1 of the pixel 15 and a second floating diffusion region FD2. The second capacitative element 32 and the second sampling transistor 34 are connected in series between the output node n1 of the pixel 15 and the second floating diffusion region FD2.

The first capacitative element 31 holds a voltage signal of the first floating diffusion region FD1 in the reset state when the first sampling transistor 33 is turned on. The first sampling transistor 33 turns on when an SR signal is at a high level. The second capacitative element 32 holds a voltage signal in a state where a signal charge is being accumulated in the first floating diffusion region FD1 when the second sampling transistor 34 is turned on. The second sampling transistor 34 turns on when an SD signal is at a high level.

The first capacitative element 31 and the second capacitative element 32 are formed by, for example, an MIM (Metal Insulator Metal) structure. For example, by forming irregularities in a part of a semiconductor layer and laminating a metal layer, an insulating layer, and a metal layer along the irregular surface, the first capacitative element 31 and the second capacitative element 32 with an MIM structure can be formed in a semiconductor process. By increasing the number of irregularities, a surface area of the metal layers can be increased and capacitance can be increased.

The first pixel circuit 16 has a current source connected between the output node n1 of the pixel 15 and a reference voltage node (for example, a ground voltage node). The current source can be constituted of, for example, two cascode-connected transistors 35 and 36. A control signal PC is input to a gate of one of the transistors and a control signal VB is input to a gate of the other transistor. The transistor 35 turns on when the control signal PC is at a high level and the transistor 36 turns on when the control signal VB is at a high level. The transistors 35 and 36 are used to precharge the first capacitative element 31 and the second capacitative element 32. Precharging the first capacitative element 31 and the second capacitative element 32 enables noise to be reduced.

As described above, in the present embodiment, the second pixel circuit 17 that is a part of the pixel circuits is shared by a plurality of pixels 15 and a plurality of first pixel circuits 16. The second pixel circuit 17 has a second reset transistor 41, a second amplifying transistor 43 that constitutes a second source follower circuit 42, a second selective transistor 44, and a current source 45.

The second reset transistor 41 is arranged between a reference voltage node VREG and the second floating diffusion region FD2. The second reset transistor 41 turns on when an RB signal is at a high level and initializes an electric charge of the second floating diffusion region FD2.

A gate of the second amplifying transistor 43 that constitutes the second source follower circuit 42 is connected to the second floating diffusion region FD2, a drain is connected to a reference voltage node VDD, and a source is connected to a drain of the second selective transistor 44. The second source follower circuit 42 generates a pixel signal in accordance with a voltage level of the second floating diffusion region FD2 and supplies the pixel signal to the second selective transistor 44.

The second selective transistor 44 turns on when an SEL signal is at a high level and outputs the pixel signal generated by the second source follower circuit 42 to the vertical signal line VSL. The SEL signal is supplied by a row selection line connected to the vertical driving portion 12 shown in Fig. 1.

Fig. 4 is a circuit diagram showing an example in which four pixels 15 and four first pixel circuits 16 share one second pixel circuit 17. Fig. 4 shows an example in which the second pixel circuit 17 is shared by a total of four pixels 15 including two pixels 15 in the first direction X (row direction) and two pixels 15 in the second direction Y (vertical direction).

As shown in Fig. 4, output nodes n2 of the four first pixel circuits 16 are connected to one second floating diffusion region FD2. Therefore, the second reset transistor 41, the second source follower circuit 42, and the second selective transistor 44 in the second pixel circuit 17 are shared by four pixels 15 and four first pixel circuits 16.

In the present specification, the four pixels 15, the four first pixel circuits 16, and the one second pixel circuit 17 shown in Fig. 4 are referred to as a unit pixel group region 40. In the example shown in Fig. 4, the photoelectric conversion element 21, the transfer transistor 22, the first reset transistor 23, the first source follower circuit 24, the first selective transistor 26, the conversion efficiency switching transistor 27, and the discharge transistor 30 that constitute the pixel 15 are arranged on the first substrate. In addition, the first capacitative element 31, the first sampling transistor 33, the second capacitative element 32, the second sampling transistor 34, and the transistor groups 35 and 36 constituting a current source that constitute the first pixel circuit 16 and the second reset transistor 41, the second source follower circuit 42, and the second selective transistor 44 that constitute the second pixel circuit 17 are arranged on the second substrate.

Fig. 5 is a sectional view showing a cross-sectional structure of the light detection device 3 according to the embodiment. As described above, the light detection device 3 according to the embodiment has a laminated structure in which three semiconductor substrates (first to third substrates) 51 to 53 are laminated. The first substrate 51 is arranged on a side of a light incident surface, the second substrate 52 is laminated on the first substrate 51, and the third substrate 53 is laminated on the second substrate 52. The first substrate 51 and the second substrate 52 are joined by metal pads and send and receive signals. More specifically, a plurality of first metal pads 63 provided on the first substrate 51 and a plurality of second metal pads 68 provided on the second substrate 52 are joined to each other and each signal is sent and received through the metal pads.

A semiconductor layer (second semiconductor layer) 64 is arranged on a side of the second substrate 52 opposing the third substrate 53, and a via 70 is provided so as to penetrate the semiconductor layer 64. Since the via penetrates the semiconductor layer (specifically, a silicon layer), the via is referred to as a TSV (Through Silicon Via) 70. A plurality of third metal pads 71 arranged at an end of the TSV 70 on a side of the third substrate 53 and a plurality of fourth metal pads 75 of the third substrate 53 are joined to each other and the second substrate 52 and the third substrate 53 send and receive signals via the metal pads 71 and 75.

A plurality of pixels 15 are arranged on the first substrate 51. A plurality of first pixel circuits 16 and a plurality of second pixel circuits 17 are arranged on the second substrate 52. A logic circuit 54 is arranged on the third substrate 53. A peripheral circuit 55 (refer to Fig. 6) including the vertical driving portion 12, the column signal processing portion 13, and the timing control portion 14 other than the pixel array portion 11 shown in Fig. 2 is arranged in a free region of at least one of the first substrate 51 and the second substrate 52 as will be described later. At least a part of the peripheral circuit 55 may be arranged on the third substrate 53.

A first semiconductor layer 56, a first wiring layer 57, a color filter 58, an on-chip lens 59, and the like are arranged on the first substrate 51.

On the first semiconductor layer 56, the photoelectric conversion element 21 is arranged for each pixel 15. For example, the photoelectric conversion element 21 is formed by arranging an n-type semiconductor region inside a p-type well region. A light-shielding wall 60 that absorbs light from an adjacent pixel 15 is arranged in a boundary region of the pixel 15. A fixed electric charge film 61 for preventing a dark current from being created is arranged on a surface of the light-shielding wall 60.

A first principal surface S1 of the first semiconductor layer 56 is a light incident surface. The first principal surface S1 has a concave-convex structure 62 for preventing reflection. The color filter 58 is arranged on the first principal surface S1 and the on-chip lens 59 is arranged on top of the color filter 58. Note that the color filter 58 and the on-chip lens 59 are not essential components and may be omitted.

A part of the pixel transistors such as the transfer transistor 22 is arranged on a second principal surface S2 of the first semiconductor layer 56 and the first wiring layer 57 is arranged above (below in Fig. 5) the pixel transistors. The first wiring layer 57 is a laminated structure having a plurality of wiring layers separated from each other by a first insulating layer 50 and a via. A plurality of the first metal pads 63 are arranged on an end surface of the first wiring layer 57 on a side of the second substrate 52.

A second semiconductor layer 64, a second wiring layer 65, a third wiring layer 66, and the like are arranged on the second substrate 52. The second wiring layer 65 is arranged on a side of a first principal surface S3 of the second semiconductor layer 64 and the third wiring layer 66 is arranged on a second principal surface S4 of the second semiconductor layer 64. The first principal surface S3 of the second semiconductor layer 64 is a side of the first substrate 51 and the second principal surface S4 is a side of the third substrate 53.

The second wiring layer 65 is a laminated structure having a plurality of wiring layers separated from each other by a second insulating layer 67 and a via. A plurality of the second metal pads 68 are arranged on an end surface of the second wiring layer 65 on a side of the first substrate 51. Each of the plurality of second metal pads 68 is joined to a corresponding first metal pad 63 and signals are transmitted and received by the first substrate 51 and the second substrate 52. One first metal pad 63 and one second metal pad 68 are respectively provided for each pixel 15 and transmit and receive voltage signals in the output node n1 of the pixel 15 shown in Fig. 3.

Respective transistors in the first pixel circuit 16 and the second pixel circuit 17 shown in Fig. 3 are arranged on the second semiconductor layer 64. A via that extends from the second wiring layer 65 is connected to the transistors.

In addition, a TSV 70 is arranged which penetrates the second semiconductor layer 64 and the third wiring layer 66 and extends to the side of the third substrate 53. The TSV 70 is connected to the vertical signal line VSL shown in Fig. 3. For example, the vertical signal line VSL is formed on the second wiring layer 65 of the second substrate 52. A plurality of the third metal pads 71 are arranged at an end of the TSV 70 on a side of the third substrate 53.

A third semiconductor layer 72, a fourth wiring layer 73, and the like are arranged on the third substrate 53. The fourth wiring layer 73 is arranged on a side of a first principal surface S5 of the third substrate 53 and the third semiconductor layer 72 is arranged on a second principal surface S6 of the third substrate 53.

The fourth wiring layer 73 is a laminated structure having a plurality of wiring layers separated from each other by a third insulating layer 74 and a via. A plurality of the fourth metal pads 75 are arranged on an end surface of the fourth wiring layer 73 on a side of the second substrate 52. Each of the plurality of fourth metal pads 75 is joined to a corresponding third metal pad 71 and signals are transmitted and received by the second substrate 52 and the third substrate 53. As many third metal pads 71 and fourth metal pads 75 as the vertical signal lines VSL are provided.

In this manner, the first wiring layer 57 and the second wiring layer 65 are arranged face to face (F to F) and the first substrate 51 and the second substrate 52 are joined by the first metal pads 63 and the second metal pads 68. In addition, the second wiring layer 65 and the fourth wiring layer 73 are arranged face to back (F to B) and the second substrate 52 and the third substrate 53 are joined by the third metal pads 71 and the fourth metal pads 75.

As shown in Fig. 5, cross-sectional structure directly below the pixel 15 and a cross-sectional structure of a region that is not directly below the pixel 15 differ from each other. A TSV 76 with a larger diameter than the TSV 70 in the pixel region is arranged from the second substrate 52 to the third substrate 53 in the region that is not directly below the pixel 15. The TSV 76 is used, for example, to make substrate contact and a predetermined reference voltage (for example, a power supply voltage or a ground voltage) is applied thereto.

Although omitted in Fig. 5, a reference contact for supplying a reference potential to at least one of the first substrate 51, the second substrate 52, and the third substrate 53 is provided. The reference contact is also referred to as a well contact.

Although a cross-sectional structure of the peripheral circuit of the pixel 15 is not illustrated on the first substrate 51 and the second substrate 52 in Fig. 5, as described later, the peripheral circuit is arranged on, for example, the first substrate 51 or the second substrate 52 directly above the TSV 76.

The peripheral circuit of the pixel 15 includes the vertical driving portion 12, the column signal processing portion 13, and the like shown in Fig. 2 and has a plurality of transistors. Each transistor in the peripheral circuit is arranged in a free region of at least one of the first substrate 51, the second substrate 52, and the third substrate 53.

Fig. 6 is a sectional view showing a first example of a cross-sectional structure of the peripheral circuit 55 of the pixel 15. In the first example, the peripheral circuit 55 of the pixel 15 is arranged on the second substrate 52. In this case, since the peripheral circuit 55 need not be arranged on the first substrate 51, the number of pixels can be increased by that amount and higher resolution can be achieved. Alternatively, the capacitance of the first capacitative element 31 and the second capacitative element 32 formed on the first substrate 51 can be increased and improved sensitivity can be achieved.

Fig. 7 is a sectional view showing a second example of the cross-sectional structure of the peripheral circuit 55 of the pixel 15. In the second example, the peripheral circuit 55 of the pixel 15 is arranged by being divided into the first substrate 51 and the second substrate 52. Arranging the peripheral circuit 55 by distributing the peripheral circuit 55 among the first to third substrates 51 to 53 enables element density of each substrate to be made uniform and makes it easier to suppress noise such as crosstalk. While a junction structure between the peripheral circuit 55 of the first substrate 51 and the peripheral circuit 55 of the second substrate 52 is not illustrated in Fig. 7, the peripheral circuits 55 may be joined by the respective metal pads described above or by vias.

Fig. 8 is a plan layout view for 2 × 2 pixels of the first substrate 51 when four pixels 15 and four first pixel circuits 16 share one second pixel circuit 17. In Fig. 8, the region of 2 × 2 pixels on the first substrate 51 and the second substrate 52 is referred to as the unit pixel group region 40. A plurality of unit pixel group regions 40 are arranged in a two-dimensional direction on the first substrate 51 and the second substrate 52. The four pixels 15 and the four first pixel circuits 16 that share one second pixel circuit 17 may be, for example, a unit pixel group of a Bayer array. In this case, the unit pixel group may consist of four pixels 15 of red (R), green (G), blue (B), and green (G) or four pixels 15 of red (R), green (G), blue (B), and white (W).

The example of the first substrate 51 shown in Fig. 8 includes the unit pixel group region 40 including two pixels each in the first direction X and the second direction Y. As shown in Fig. 8, the unit pixel group region 40 including four pixels 15 is arranged in plurality in a two-dimensional direction on the first substrate 51. The transfer transistor 22, the first reset transistor 23, the first source follower circuit 24, the first selective transistor 26, the discharge transistor 30, and the conversion efficiency switching transistor 27 are arranged in each unit pixel group region 40. The photoelectric conversion element 21 is arranged over almost the entirety of each pixel region below the transistors. More specifically, as shown in Fig. 8, a gate TRG of the transfer transistor 22, a gate RST of the first reset transistor 23, a gate SF1 of the first source follower circuit 24, a gate SW of the first selective transistor 26, a gate FDG of the conversion efficiency switching transistor 27, and a gate OFG of the discharge transistor 30 are respectively arranged in the unit pixel group region 40 across a diffusion layer 37. A white portion in each pixel region is an insulating layer 38.

Fig. 9 is a plan layout view of a unit pixel group region 40 for 2 × 2 pixels of the second substrate 52 that is laminated on the first substrate 51 shown in Fig. 8. A plurality of unit pixel group regions 40 are arranged in a two-dimensional direction on the second substrate 52. Four first pixel circuits 16 and one second pixel circuit 17 are arranged in each unit pixel group region 40. In addition, while one TSV 70 is arranged in each unit pixel group region 40, the TSV is not illustrated in Fig. 9.

In the example shown in Fig. 9, arranged along the first direction X in a region of four pixels are: a first row in which two sets of the transistor groups 35 and 36 that constitute current sources are lined up; a second row in which two sets are lined up, each set consisting of the first sampling transistor 33 and the second sampling transistor 34; a third row in which the second selective transistor 44, the second source follower circuit 42, and the second reset transistor 41 are lined up; a fourth row in which two sets are lined up, each set consisting of the first sampling transistor 33 and the second sampling transistor 34; and a fifth row in which the two transistor groups 35 and 36 that constitute current sources are lined up. In each row, the gate and the diffusion region of each transistor are arranged along the first direction X.

For example, in the first and fifth rows, the gates VB, PC, PC, and VB of the two transistor groups 35 and 36 that constitute current sources are arranged along the first direction X in this order with the diffusion layer 37 sandwiched between the respective gates. In the second and fourth rows, the well contact region WC, the gates SD, SR, SR, and SD of the first and second sampling transistors 34 and 33, and the well contact region WC are arranged along the first direction X in this order with the diffusion layer 37 sandwiched between the respective gates. In the third row, the gate SEL of the second selective transistor 44, the gate SF2 of the second source follower circuit 42, and the gate RB of the second reset transistor 41 are arranged along the first direction X in this order with the diffusion layer 37 sandwiched between the respective gates.

As described above, the respective transistors and the like that constitute the four first pixel circuits 16 and the one second pixel circuit 17 are arranged symmetrically on the second substrate 52. More specifically, the gate SF2 of the second source follower circuit 42 is arranged in approximately the center of the unit pixel group region 40, the gates SR of the two or more first sampling transistors 33 are located at equal distances from the gate SF2, and the gates SD of the two or more second sampling transistors 34 are located at equal distances from the gate SF2.

In particular, in the example shown in Fig. 9, all of the directions of extension of channels of the respective transistors (hereinafter, simply referred to as channel directions or gate length directions) are the first direction X and the diffusion layer 37 is arranged on both sides in the first direction X of the channel of each transistor. Accordingly, transistors adjacent to each other in the first direction X are to be arranged across their respective diffusion layers 37 and a risk of channels being modulated due to the effect of adjacent transistors can be avoided.

In addition, although illustration of the TSV 70 is omitted in Fig. 9, for example, the TSV 70 is arranged along the third row positioned in a central part in the second direction Y of the unit pixel group bizarre 40. More specifically, for example, the TSV 70 is arranged in a vicinity of the gate SEL of the second selective transistor 44. Accordingly, the TSV 70 is to be arranged across the diffusion layer 37 of the second selective transistor 44 that is adjacent in the first direction X and a risk of a signal variation of the TSV 70 modulating the channel of the second selective transistor 44 can be avoided. Note that the TSV 70 can be arranged along a row other than the third row shown in Fig. 9.

As described above, the first substrate 51 and the second substrate 52 transmit and receive signals due to joining of the first metal pads 63 and the second metal pads 68 and the second substrate 52 and the third substrate 53 transmit and receive signals due to joining of the third metal pads 71 and the fourth metal pads 75 arranged at the end of the TSV 70 that penetrates the second semiconductor layer 64 on the second substrate 52. Arrangement locations and sizes of the metal pads are arbitrary.

In Fig. 9, the gate SF2 of the second source follower circuit 42 is arranged in a central part of the unit pixel group region 40 with 2 × 2 pixels 15 of the second substrate 52 as a unit. In addition, the gates SD of four first sampling transistors 33 and the gates SR of four second sampling transistors 34 are arranged in point symmetry or line symmetry with respect to the gate SF2 in the unit pixel group region 40.

When reading out a pixel signal, there is a risk that each gate of the first sampling transistor 33 and the second sampling transistor 34 which perform control so as to hold voltage signals in the first capacitative element 31 and the second capacitative element 32 may cause crosstalk to occur in the channel directly below the gate SF2 of the second source follower circuit 42 in a subsequent stage. In particular, when a plurality of pixels 15 and a plurality of first pixel circuits 16 share one second pixel circuit 17, if distances from the gates SR and SD of the first and second sampling transistors 33 and 34 to the gate SF2 of the second source follower circuit 42 differ for each shared pixel, a magnitude of the crosstalk also varies for each pixel and may cause image quality to decline.

In consideration thereof, in Fig. 9, the gates SR of the four first sampling transistors 33 are arranged in point symmetry or line symmetry and the gates SD of the four second sampling transistors 34 are arranged in point symmetry or line symmetry with respect to the gate SF2 of the second source follower circuit.

Accordingly, the distances between the gate SF2 of the second source follower circuit 42 and the gates SR of the four first sampling transistors 33 become uniform and the distances between the gate SF2 of the second source follower circuit 42 and the gates SD of the four second sampling transistors 33 become uniform. Therefore, an effect of crosstalk becomes the same in all pixels 15 and a difference in output among colors can be eliminated.

A layout arrangement of the second substrate 52 is not limited to that shown in Fig. 9 and various modifications are conceivable. Fig. 10 is a plan layout view of the second substrate 52 according to a first modification of Fig. 9. The unit pixel group region 40 according to the first modification shown in Fig. 10 has a layout arrangement in which the first row and the second row in Fig. 9 have been swapped and the fourth row and the fifth row in Fig. 9 have been swapped. Even in the first modification shown in Fig. 10, the gates SR of the first sampling transistors 33 of four pixels and the gates SD of the second sampling transistors 34 of four pixels are arranged in point symmetry or line symmetry with respect to the gate SF2 of the second source follower circuit 42 arranged in a central part in the unit pixel group region 40.

Accordingly, since the distances between the gate SF2 of the second source follower circuit 42 and the gates SR of the first sampling transistors 33 of the four pixels become uniform and the distances between the gate SF2 of the second source follower circuit 42 and the gates SD of the four second sampling transistors 33 become uniform, the effect of crosstalk can be made uniform in all pixels and an improvement in image quality can be achieved.

In the layout arrangements of the second substrate 52 shown in Figs. 9 and 10, the gate of each transistor in the first pixel circuit 16 and the second pixel circuit 17 extends in the first direction X and the diffusion layer 37 is arranged on both sides in the first direction X of each gate. The direction in which the gates extend and an arrangement direction of the diffusion layer 37 of at least a part of the transistors may be the second direction Y that intersects with the first direction X.

Fig. 11 is a plan layout view of the second substrate 52 according to a second modification of Fig. 9. As shown in Fig. 11, one row that extends in the first direction X is arranged in a central part in the second direction Y in the unit pixel group region 40 of the second substrate 52 according to the second modification. In this row, the gate SEL of the second selective transistor 44, the gate SF2 of the second source follower circuit 42, and the gate RB of the second reset transistor 41 are arranged along the first direction X in this order. The channels of the transistors extend in the first direction X and the diffusion layer 37 is arranged at both ends of the channels in the first direction X.

In addition, as shown in Fig. 11, four columns (first to fifth columns) lined up in the first direction X are arranged in the unit pixel group region 40 of the second substrate 52 according to the second modification. All of the first to fifth columns extend in the second direction Y. The first to fifth columns are divided by the row described above at the central part in the second direction Y. In the first and fifth columns, the gates VB, PC, PC, and VB of the two transistor groups 35 and 36 that constitute current sources are arranged along the second direction Y in this order with the diffusion layer 37 sandwiched between the respective gates. In the second and third columns, the gate SD of the second sampling transistor 34, the gate SR of the first sampling transistor 33, the gate SR of the first sampling transistor 33, and the gate SD of the second sampling transistor 34 are arranged along the second direction Y in this order with the diffusion layer 37 sandwiched between the respective gates. In addition, two well contact regions WC are arranged along the second direction Y in the third column.

In this manner, in the unit pixel group region 40 of the second substrate 52 according to the second modification, as shown in Fig. 11, the gate SF2 of the second source follower circuit 42 is arranged in a central part of the unit pixel group region 40, and the gates SR of the first sampling transistors 33 of four pixels and the gates SD of the second sampling transistors 34 of four pixels are arranged in point symmetry or line symmetry with respect to the gate SF2.

Accordingly, since the distances between the gate SF2 of the second source follower circuit 42 and the gates SR of the first sampling transistors 33 of the four pixels become uniform and the distances between the gate SF2 of the second source follower circuit 42 and the gates SD of the four second sampling transistors 33 become uniform, the effect of crosstalk can be made uniform in all pixels and an improvement in image quality can be achieved.

Fig. 12 is a plan layout view of the second substrate 52 according to a third modification of Fig. 9. As shown in Fig. 12, the unit pixel group region 40 of the second substrate 52 according to the third modification has a layout arrangement in which the first column and the second column in Fig. 11 have been swapped and the fourth column and the fifth column in Fig. 11 have been swapped. Even in the third modification shown in Fig. 12, the gates SR of the first sampling transistors 33 of four pixels and the gates SD of the second sampling transistors 34 of four pixels are arranged in point symmetry or line symmetry with respect to the gate SF2 of the second source follower circuit 42 arranged in a central part in the unit pixel group region 40.

Fig. 13 is a plan layout view of the second substrate 52 according to a fourth modification of Fig. 9. As shown in Fig. 13, the unit pixel group region 40 of the second substrate 52 according to the fourth modification includes the gate SF2 of the second source follower circuit 42 that is arranged in a central part in the second direction Y of the unit pixel group region 40. The gate SF2 has a larger area than the gates of the other transistors for improving symmetry. A gate length direction of the gate is the first direction X and the diffusion layer 37 is arranged on both sides in the second direction Y of the gate.

In addition, as shown in Fig. 13, the unit pixel group region 40 of the second substrate 52 according to the fourth modification includes five columns (first to fifth columns) lined up in the first direction X. All of the first to fifth columns extend in the second direction Y and are divided at the central part of the second direction Y. In the first and fifth columns, the gates VB, PC, PC, and VB of the two transistor groups 35 and 36 that constitute current sources are arranged along the second direction Y in this order with the diffusion layer 37 sandwiched between the respective gates. In the second and fourth columns, the gate SD of the second sampling transistor 34, the gate SR of the first sampling transistor 33, the gate SR of the first sampling transistor 33, and the gate SD of the second sampling transistor 34 are arranged along the second direction Y in this order with the diffusion layer 37 sandwiched between the respective gates. In the third column, the well contact region WC, the gate RB of the second reset transistor 41, and the gate SEL of the second selective transistor 44 are arranged along the second direction Y in this order with the diffusion layer 37 sandwiched between the respective gates.

The gate SF2 of the second source follower circuit 42 is arranged so as to divide the second to fourth columns at the central part of the second direction Y.

As shown in Fig. 13, the unit pixel group region 40 of the second substrate 52 according to the fourth modification includes the gate SF2 of the second source follower circuit 42 that is arranged in a central part of the unit pixel group region 40, the gates SR of the first sampling transistors 33 of four pixels that are arranged in point symmetry or line symmetry with respect to the gate SF2, and the gates SD of the second sampling transistors 34 of four pixels that are similarly arranged in point symmetry or line symmetry with respect to the gate SF2.

Accordingly, the distances between the gate SF2 of the second source follower circuit 42 and the gates SR of the four first sampling transistors 33 become uniform and the distances between the gate SF2 of the second source follower circuit 42 and the gates SD of the four second sampling transistors 33 become uniform. Therefore, an effect of crosstalk becomes uniform in all pixels 15 and a difference in output among colors can be eliminated.

Fig. 14 is a plan layout view of the second substrate 52 according to a fifth modification of Fig. 9. As shown in Fig. 14, the unit pixel group region 40 of the second substrate 52 according to the fourth modification has a layout arrangement in which the first column and the second column in Fig. 13 have been swapped and the fourth column and the fifth column in Fig. 13 have been swapped. Even in Fig. 14, the gates SR of the first sampling transistors 33 of four pixels and the gates SD of the second sampling transistors 34 of four pixels are arranged in point symmetry or line symmetry with respect to the gate SF2 of the second source follower circuit 42 arranged in a central part in the unit pixel group region 40. Therefore, a similar effect to Figs. 9 to 13 is produced.

A channel direction of a part of the transistors in the unit pixel group region 40 may be arranged in a direction that differs from Figs. 13 and 14.

Fig. 15 is a plan layout view of the second substrate 52 according to a sixth modification of Fig. 9. As shown in Fig. 15, the unit pixel group region 40 of the second substrate 52 according to the sixth modification includes a first row, a second row, a third row, and a fourth row that represent a change in an orientation in which the first column, the second column, the fourth column, and the fifth column in Fig. 14 extend from the second direction Y to the first direction X. The first to fourth rows are divided at the central part of the first direction X.

In the first and fourth rows, the gates VB, PC, PC, and VB of the two transistor groups 35 and 36 that constitute current sources are arranged along the first direction X in this order with the diffusion layer 37 sandwiched between the respective gates. In the second and third rows, the gate SD of the second sampling transistor 34, the gate SR of the first sampling transistor 33, the gate SR of the first sampling transistor 33, and the gate SD of the second sampling transistor 34 are arranged along the first direction X in this order with the diffusion layer 37 sandwiched between the respective gates.

At the central part in the first direction X of the unit pixel group region 40 shown in Fig. 15, the well contact region WC, the gate RB of the second reset transistor 41, the gate SF2 of the second source follower circuit 42, and the gate SEL of the second selective transistor 44 are arranged in this order along the second direction Y, with the diffusion layer 37 sandwiched between the respective gates.

Even in the unit pixel group region 40 of the second substrate 52 according to the sixth modification, the gates SR of the first sampling transistors 33 of four pixels and the gates SD of the second sampling transistors 34 of four pixels are arranged in point symmetry or line symmetry with respect to the gate SF2 of the second source follower circuit 42 and a similar effect to Figs. 9 to 14 is produced.

Fig. 16 is a plan layout view of the second substrate 52 according to a seventh modification of Fig. 9. As shown in Fig. 16, the unit pixel group region 40 of the second substrate 52 according to the seventh modification has a layout arrangement in which the first row and the second row in Fig. 15 have been swapped and the third row and the fourth row in Fig. 15 have been swapped. Even in Fig. 16, the gates SR of the first sampling transistors 33 of four pixels and the gates SD of the second sampling transistors 34 of four pixels are arranged in point symmetry or line symmetry with respect to the gate SF2 of the second source follower circuit 42 and a similar effect to Figs. 9 to 15 is produced.

As described above, there is a risk that each gate of the first sampling transistor 33 and the second sampling transistor 34 may cause crosstalk to occur in a channel directly below the gate SF2 of the second source follower circuit 42 in a subsequent stage. One conceivable countermeasure to suppress the effects of such crosstalk is to use a twin structure for the gate of the second source follower circuit 42. The example described below is provided with two second amplifying transistors 43 that constitute the second source follower circuit 42.

Fig. 17 is a plan layout view of the second substrate 52 according to an eighth modification of Fig. 9. As shown in Fig. 17, the unit pixel group region 40 of the second substrate 52 according to the eighth modification includes five columns (first to fifth columns) lined up in the first direction X. Two gates SF2 of the second source follower region are provided in one second pixel circuit 17 that is shared by four pixels 15 and four first pixel circuits 16.

In the first and fifth columns, the gates VB, PC, PC, and VB of the two transistor groups 35 and 36 that constitute current sources are arranged along the second direction Y in this order with the diffusion layer 37 sandwiched between the respective gates. A dummy gate 80 is arranged between two gates PC adjacent to each other in the second direction Y of the first column and the fifth column. The dummy gate 80 is arranged so as to ensure symmetry and make crosstalk uniform. In the second and fourth columns, the gate SD of the second sampling transistor 34, the gate SR of the first sampling transistor 33, the gates SF2 of the second source follower circuit 42, the gate SR of the first sampling transistor 33, and the gate SD of the second sampling transistor 34 are arranged along the second direction Y in this order with the diffusion layer 37 sandwiched between the respective gates. In the third column, the well contact region WC, the gate RB of the second reset transistor 41, the dummy gate 80, and the gate SEL of the second selective transistor 44 are arranged along the second direction Y in this order with the diffusion layer 37 sandwiched between the respective gates.

As shown in Fig. 17, on the second substrate 52 according to the eighth modification, the two gates SF2 of the second source follower circuit 42 are arranged in a central part in the second direction Y of the unit pixel group region 40, and the gates SR of the first sampling transistors 33 of four pixels and the gates SD of the second sampling transistors 34 of four pixels are arranged in point symmetry or line symmetry with respect to the gates SF2.

Giving the gate SF2 of the second source follower circuit 42 a twin structure enables an effect of crosstalk on the gates SR and SD of the first and second sampling transistors 33 and 34 of four pixels to be made uniform.

Fig. 18 is a plan layout view of the second substrate 52 according to a ninth modification of Fig. 9. As shown in Fig. 18, the unit pixel group region 40 of the second substrate 52 according to the ninth modification has a layout arrangement in which the first column and the second column in Fig. 17 have been swapped and the fourth column and the fifth column in Fig. 17 have been swapped.

Even in Fig. 18, the gates SR and SD of the first and second sampling transistors 33 and 34 are arranged in point symmetry or line symmetry with respect to the two gates SF2 of the second source follower circuit 42 in a central part in the second direction Y of the unit pixel group region 40 and the effect of crosstalk can be made uniform.

While channel directions of all of the transistors in the unit pixel group region 40 shown in Figs. 17 and 18 are arranged in the second direction Y, the channel direction of at least a part of the transistors may be arranged in the first direction X.

Fig. 19 is a plan layout view of the second substrate 52 according to a tenth modification of Fig. 9. As shown in Fig. 19, the unit pixel group region 40 of the second substrate 52 according to the tenth modification has four rows (first to fourth row) arranged in the second direction Y and extending in the first direction X, the gate RB of the second reset transistor 41 arranged along the first direction X in the central part in the second direction Y, the two gates SF2 of the second source follower circuit 42, and the gate SEL of the second selective transistor 44.

In the first and fourth rows, the gates VB and PC of the transistor groups 35 and 36 that constitute current sources, the well contact region WC, and the gates PC and VB of the transistor groups 35 and 36 are arranged along the first direction X in this order with the diffusion layer 37 sandwiched between the respective gates.

In the second and third rows, the gate SD of the second sampling transistor 34, the gate SR of the first sampling transistor 33, the gate SR of the first sampling transistor 33, and the gate SD of the second sampling transistor 34 are arranged along the first direction X in this order with the diffusion layer 37 sandwiched between the respective gates.

Even in Fig. 19, the gates SR and SD of the first and second sampling transistors 33 and 34 are arranged in point symmetry or line symmetry with respect to the two gates SF2 of the second source follower circuit 42 in a central part in the second direction Y of the unit pixel group region 40 and the effect of crosstalk can be made uniform.

Fig. 20 is a plan layout view of the second substrate 52 according to an eleventh modification of Fig. 9. As shown in Fig. 20, the unit pixel group region 40 of the second substrate 52 according to the eleventh modification has a layout arrangement in which the first row and the second row in Fig. 19 have been swapped and the third row and the fourth row in Fig. 19 have been swapped.

Even in Fig. 20, the gates SR and SD of the first and second sampling transistors 33 and 34 are arranged in point symmetry or line symmetry with respect to the two gates SF2 of the second source follower circuit 42 in a central part in the second direction Y of the unit pixel group region 40 and the effect of crosstalk can be made uniform.

The circuit configurations of the pixel 15 and the pixel circuits are not limited to the circuit configurations shown in Fig. 3. The light detection device 3 according to the present disclosure can also be applied to pixels 15 and pixel circuit with circuit configurations other than those shown in Fig. 3.

Fig. 21 is a circuit diagram of the pixel 15 and pixel circuits according to a modification of Fig. 3. The first pixel circuit 16 shown in Fig. 21 has a first output node SF21 and a second output node SF22 and a separate second pixel circuit 17 is connected to each of the first output node SF21 and the second output node SF22. One of the second pixel circuits 17 has a second source follower circuit 42R and a second selective transistor 44R and the other second pixel circuit 17 has a second source follower circuit 42D and a second selective transistor 44D.

The first pixel circuit 16 shown in Fig. 21 is connected to the output node n1 of the pixel 15 and has the transistor groups 35 and 36 that constitute current sources, the first sampling transistor 33 and the first capacitative element 31, and the second sampling transistor 34 and the second capacitative element 32. The first capacitative element 31 is connected between a reference voltage node and the first output node SF21. The first sampling transistor 33 is connected between the first output node SF21 and the output node n1 of the pixel 15. The second capacitative element 32 is connected between the reference voltage node and the second output node SF22. The second sampling transistor 34 is connected between the second output node SF22 and the output node n1 of the pixel 15.

Fig. 22 is a circuit diagram in a case where four pixels 15 and four first pixels 15 share one second pixel circuit 17 according to the circuit configuration shown in Fig. 21. Although Fig. 21 has two second pixel circuits 17, Fig. 22 has one second pixel circuit 17 and a third selective transistor 38 is arranged between the output node n1 of the pixel 15 and an input node of the second pixel circuit 17. The third selective transistor 38 turns on when a PSEL signal is at a high level.

Fig. 23 is a plan layout view of a unit pixel group region 40 for 4 × 4 pixels of the second substrate 52 that is constituted of the pixel 15 and the pixel circuits shown in Fig. 22. The unit pixel group region 40 shown in Fig. 23 includes five rows (first to fifth rows). In the first and fifth rows, the gates VB, PC, PC, and VB of the two transistor groups 35 and 36 that constitute current sources are arranged along the first direction X in this order with the diffusion layer 37 sandwiched between the respective gates. In the second and fourth rows, the gate PSEL of the third selective transistor 38, the gate SD of the second sampling transistor 34, the gate SR of the first sampling transistor 33, the gate SR of the first sampling transistor 33, the gate SD of the second sampling transistor 34, and the gate PSEL of the third selective transistor 38 are arranged along the first direction X in this order with the diffusion layer 37 sandwiched between the respective gates. In the third row, the gate SEL of the second selective transistor 44, the gate SF2 of the second source follower circuit 42, and the well contact region WC are arranged along the first direction X in this order with the diffusion layer 37 sandwiched between the respective gates.

In Fig. 23, the gates SR and SD of the first and second sampling transistors 33 and 34 are arranged in point symmetry or line symmetry with respect to the gate SF2 of the second source follower circuit 42 that is arranged in a central part of the unit pixel group region 40.

Accordingly, the distances between the gate SF2 of the second source follower circuit 42 and the gates SR of the four first sampling transistors 33 become uniform and the distances between the gate SF2 of the second source follower circuit 42 and the gates SD of the four second sampling transistors 33 become uniform. Therefore, an effect of crosstalk becomes the same in all pixels 15 and a difference in output among colors can be eliminated.

Fig. 24 is a plan layout view of the second substrate 52 according to a first modification of Fig. 23. As shown in Fig. 24, the unit pixel group region 40 of the second substrate 52 according to the first modification has a layout arrangement in which the first row and the second row in Fig. 23 have been swapped and the fourth row and the fifth row in Fig. 23 have been swapped.

Even in Fig. 24, the gates SR and SD of the first and second sampling transistors 33 and 34 are arranged in point symmetry or line symmetry with respect to the gate SF2 of the second source follower circuit 42 that is arranged in a central part of the unit pixel group region 40. Therefore, a similar effect to the layout arrangement of Fig. 23 is produced.

Fig. 25 is a plan layout view of the second substrate 52 according to a second modification of Fig. 23. As shown in Fig. 25, the unit pixel group region 40 of the second substrate 52 according to the second modification includes four columns (first to fourth columns) and one row.

In the first and fourth columns, the gates VB, PC, PC, and VB of the two transistor groups 35 and 36 that constitute current sources are arranged along the second direction Y in this order. In the second and third columns, the gate PSEL of the third selective transistor 38, the gate SD of the second sampling transistor 34, the gate SR of the first sampling transistor 33, the gate SR of the first sampling transistor 33, the gate SD of the second sampling transistor 34, and the gate PSEL of the third selective transistor 38 are arranged along the second direction Y in this order with the diffusion layer 37 sandwiched between the respective gates.

In one row arranged in the central part in the second direction Y of the unit pixel group region 40, the gate SEL of the second selective transistor 44, the gate SF2 of the second source follower circuit 42, and the well contact region WC are arranged along the first direction X in this order with the diffusion layer 37 sandwiched between the respective gates.

Even in Fig. 25, the gates SR and SD of the first and second sampling transistors 33 and 34 are arranged in point symmetry or line symmetry with respect to the gate SF2 of the second source follower circuit 42 that is arranged in a central part of the unit pixel group region 40. Therefore, a similar effect to the layout arrangement of Fig. 23 is produced.

Fig. 26 is a plan layout view of the second substrate 52 according to a third modification of Fig. 23. As shown in Fig. 26, the unit pixel group region 40 of the second substrate 52 according to the third modification has a layout arrangement in which the first column and the second column in Fig. 25 have been swapped and the third column and the fourth column in Fig. 25 have been swapped.

Even in Fig. 26, the gates SR and SD of the first and second sampling transistors 33 and 34 are arranged in point symmetry or line symmetry with respect to the gate SF2 of the second source follower circuit 42 that is arranged in a central part of the unit pixel group region 40. Therefore, a similar effect to the layout arrangement of Fig. 23 is produced.

Fig. 27 is a plan layout view of the second substrate 52 according to a fourth modification of Fig. 23. As shown in Fig. 27, the unit pixel group region 40 of the second substrate 52 according to the fourth modification differs from Fig. 25 in that the direction in which the gate SF2 of the second source follower circuit 42 extends is the second direction Y. Otherwise, the layout arrangement is the same as that shown in Fig. 25. A diffusion layer of the second source follower circuit 42 is arranged on the sides of both ends in the second direction Y of the gate SF2.

Even in Fig. 27, the gates SR and SD of the first and second sampling transistors 33 and 34 are arranged in point symmetry or line symmetry with respect to the gate SF2 of the second source follower circuit 42 that is arranged in a central part of the unit pixel group region 40. Therefore, a similar effect to the layout arrangement of Fig. 23 is produced.

Fig. 28 is a plan layout view of the second substrate 52 according to a fifth modification of Fig. 23. As shown in Fig. 28, the unit pixel group region 40 of the second substrate 52 according to the fifth modification differs from Fig. 26 in that the direction in which the gate SF2 of the second source follower circuit 42 extends is the second direction Y. Otherwise, the layout arrangement is the same as that shown in Fig. 26.

Even in Fig. 28, the gates SR and SD of the first and second sampling transistors 33 and 34 are arranged in point symmetry or line symmetry with respect to the gate SF2 of the second source follower circuit 42 that is arranged in a central part of the unit pixel group region 40. Therefore, a similar effect to the layout arrangement of Fig. 23 is produced.

Fig. 29 is a plan layout view of the second substrate 52 according to a sixth modification of Fig. 23. As shown in Fig. 29, the unit pixel group region 40 of the second substrate 52 according to the sixth modification differs from Fig. 23 in that the direction in which the gate SF2 of the second source follower circuit 42 extends is the second direction Y. Otherwise, the layout arrangement is the same as that shown in Fig. 23.

Even in Fig. 29, the gates SR and SD of the first and second sampling transistors 33 and 34 are arranged in point symmetry or line symmetry with respect to the gate SF2 of the second source follower circuit 42 that is arranged in a central part of the unit pixel group region 40. Therefore, a similar effect to the layout arrangement of Fig. 23 is produced.

Fig. 30 is a plan layout view of the second substrate 52 according to a seventh modification of Fig. 23. As shown in Fig. 30, the unit pixel group region 40 of the second substrate 52 according to the seventh modification differs from Fig. 24 in that the direction in which the gate SF2 of the second source follower circuit 42 extends is the second direction Y. Otherwise, the layout arrangement is the same as that shown in Fig. 24.

Even in Fig. 30, the gates SR and SD of the first and second sampling transistors 33 and 34 are arranged in point symmetry or line symmetry with respect to the gate SF2 of the second source follower circuit 42 that is arranged in a central part of the unit pixel group region 40. Therefore, a similar effect to the layout arrangement of Fig. 23 is produced.

While Fig. 4 shows an example in which four pixels 15 and four first pixels 15 share one second pixel 15, a unit of sharing by the pixels 15 is not limited to four pixels. For example, one second pixel 15 may be shared with one pixel 15 in the first direction X (for example, a horizontal direction) and two pixels 15 in the second direction Y (for example, a vertical direction) as the unit pixel group region 40.

Fig. 31 is a circuit diagram in a case where two pixels 15 and two first pixel circuits 16 share one second pixel circuit 17 using the pixel 15, the first pixel circuit 16, and the second pixel circuit 17 according to the circuit configuration shown in Fig. 3. As shown in Fig. 31, the two pixels 15 and the two first pixel circuits 16 arranged in the second direction Y are objects to be shared, and the two first pixel circuits 16 and the one second pixel circuit 17 share the second floating diffusion region FD2. Fig. 31 illustrates circuit configurations of four pixels, in which the two (upper and lower) first pixel circuits 16 on a left side are connected to one second pixel circuit 17 and the two (upper and lower) first pixel circuits 16 on a right side are connected to one other second pixel circuit 17.

Fig. 32 is a plan layout view of a region in which two unit pixel group regions 40 for 1 × 2 pixels of the second substrate 52 that is constituted of the pixel 15 and the pixel circuits shown in Fig. 31 are lined up in the first direction X. The region shown in Fig. 32 in which two unit pixel group regions 40 are lined up includes five rows (first to fifth rows). In the first and fifth rows, the gates VB and PC of the transistor groups 35 and 36 that constitute current sources, the gate RB of the second reset transistor 41, and the gates PC and VB of the transistor groups 35 and 36 that constitute current sources are arranged along the first direction X in this order with the diffusion layer 37 sandwiched between the respective gates. In the second and fourth rows, the gate SD of the second sampling transistor 34, the gate SR of the first sampling transistor 33, the well contact region WC, the gate SR of the first sampling transistor 33, and the gate SD of the second sampling transistor 34 are arranged along the first direction X in this order. In the third row, the gate SEL of the second selective transistor 44, the gate SF2 of the second source follower circuit 42, the gate SF2 of the second source follower circuit 42, and the gate SEL of the second selective transistor 44 are arranged along the first direction X in this order with the diffusion layer 37 sandwiched between the respective gates.

In Fig. 32, the gates SF2 of the two second source follower circuits 42 are arranged along the first direction X in the central part in the second direction Y in the region where the two unit pixel group regions 40 are lined up, and the gates SR and SD of the first and second sampling transistors 33 and 34 of two pixels are arranged in point symmetry or line symmetry with respect to the gates SF2.

Accordingly, the distances between the gates SF2 of the second source follower circuits 42 and the gates SR of the two first sampling transistors 33 become uniform and the distances between the gates SF2 of the second source follower circuits 42 and the gates SD of the two second sampling transistors 33 become uniform. Therefore, an effect of crosstalk becomes the same in all pixels 15 and a difference in output among colors can be eliminated.

Fig. 33 is a plan layout view of the second substrate 52 according to a first modification of Fig. 32. As shown in Fig. 33, the region in which two unit pixel group regions 40 of the second substrate 52 according to the first modification are lined up has a layout configuration in which the first row and the second row in Fig. 32 have been swapped and the fourth row and the fifth row in Fig. 32 have been entered and changed.

Even in Fig. 33, the gates SR and SD of the first and second sampling transistors 33 and 34 are arranged in point symmetry or line symmetry with respect to the gates SF2 of the two second source follower circuit 42 that are arranged in a central part of the region where the two unit pixel group regions 40 are lined up. Therefore, a similar effect to the layout arrangement of Fig. 32 is produced.

Fig. 34 is a plan layout view of the second substrate 52 according to a second modification of Fig. 32. As shown in Fig. 34, the region in which two unit pixel group regions 40 of the second substrate 52 according to the second modification are lined up includes five columns (first to fifth columns) and one row.

In the first and fifth columns, the gates VB, PC, PC, and VB of the two transistor groups 35 and 36 that constitute current sources are arranged along the second direction Y in this order with the diffusion layer 37 sandwiched between the respective gates. In the second and fourth columns, the gate SD of the second sampling transistor 34, the gate SR of the first sampling transistor 33, the gate SR of the first sampling transistor 33, and the gate SD of the second sampling transistor 34 are arranged along the second direction Y in this order with the diffusion layer 37 sandwiched between the respective gates.

In the third column, the well contact region WC, the gate RB of the second reset transistor 41, the gate RB of the second reset transistor 41, and the well contact region WC are arranged along the second direction Y in this order.

Even in Fig. 34, the gates SR and SD of the first and second sampling transistors 33 and 34 are arranged in point symmetry or line symmetry with respect to the gates SF2 of the two second source follower circuit 42 that are arranged in a central part of the region where the two unit pixel group regions 40 are lined up. Therefore, a similar effect to the layout arrangement of Fig. 32 is produced.

Fig. 35 is a plan layout view of the second substrate 52 according to a third modification of Fig. 32. As shown in Fig. 35, the region in which two unit pixel group regions 40 of the second substrate 52 according to the third modification are lined up has a layout configuration in which the first column and the second column in Fig. 34 have been swapped and the fourth column and the fifth column in Fig. 34 have been swapped.

Even in Fig. 35, the gates SR and SD of the first and second sampling transistors 33 and 34 are arranged in point symmetry or line symmetry with respect to the gates SF2 of the two second source follower circuit 42 that are arranged in a central part of the region where the two unit pixel group regions 40 are lined up. Therefore, a similar effect to the layout arrangement of Fig. 32 is produced.

Fig. 36 is a plan layout view of the second substrate 52 according to a fourth modification of Fig. 32. As shown in Fig. 36, the region in which two unit pixel group regions 40 of the second substrate 52 according to the fourth modification are lined up includes five columns (first to fifth columns).

In the first and fifth columns, the gates VB and PC of the transistor groups 35 and 36 that constitute current sources, the well contact region WC, and the gates PC and VB of the transistor groups 35 and 36 that constitute current sources are arranged along the second direction Y in this order with the diffusion layer 37 sandwiched between the respective gates. In the second and fourth columns, the gate SD of the second sampling transistor 34, the gate SR of the first sampling transistor 33, the gates SF2 of the second source follower circuit 42, the gate SR of the first sampling transistor 33, and the gate SD of the second sampling transistor 34 are arranged along the second direction Y in this order with the diffusion layer 37 sandwiched between the respective gates. In the third column, the gate SEL of the second selective transistor 44, the gate RB of the second reset transistor 41, the gate RB of the second reset transistor 41, and the gate SEL of the second selective transistor 44 are arranged along the second direction Y in this order with the diffusion layer 37 sandwiched between the respective gates.

Even in Fig. 36, the gates SR and SD of the first and second sampling transistors 33 and 34 are arranged in point symmetry or line symmetry with respect to the gates SF2 of the two second source follower circuit 42 that are arranged in a central part of the region where the two unit pixel group regions 40 are lined up. Therefore, a similar effect to the layout arrangement of Fig. 32 is produced.

Fig. 37 is a plan layout view of the second substrate 52 according to a fifth modification of Fig. 32. As shown in Fig. 37, the region in which two unit pixel group regions 40 of the second substrate 52 according to the fifth modification are lined up has a layout arrangement in which the first column and the second column in Fig. 36 have been swapped and the fourth column and the fifth column in Fig. 36 have been swapped.

Even in Fig. 37, the gates SR and SD of the first and second sampling transistors 33 and 34 are arranged in point symmetry or line symmetry with respect to the gates SF2 of the two second source follower circuit 42 that are arranged in a central part of the region where the two unit pixel group regions 40 are lined up. Therefore, a similar effect to the layout arrangement of Fig. 32 is produced.

Fig. 38 is a plan layout view of the second substrate 52 according to a sixth modification of Fig. 32. As shown in Fig. 38, the region in which two unit pixel group regions 40 of the second substrate 52 according to the sixth modification are lined up includes five rows (first to fifth rows) and one column.

In the first and fifth rows, the gates VB, PC, PC, and VB of the two transistor groups 35 and 36 that constitute current sources are arranged along the first direction X in this order with the diffusion layer 37 sandwiched between the respective gates. In the second and fourth rows, the gate SD of the second sampling transistor 34, the gate SR of the first sampling transistor 33, the gate SR of the first sampling transistor 33, and the gate SD of the second sampling transistor 34 are arranged along the first direction X in this order. In the third row, the well contact region WC, the gate SF2 of the second source follower circuit 42, the gate SF2 of the second source follower circuit 42, and the well contact region WC are arranged along the first direction X in this order with the diffusion layer 37 sandwiched between the respective gates. While the channel direction of each transistor in the third row is arranged along the second direction Y, the channel direction of each transistor in the other rows is arranged along the first direction X.

Even in Fig. 38, the gates SR and SD of the first and second sampling transistors 33 and 34 are arranged in point symmetry or line symmetry with respect to the gates SF2 of the two second source follower circuit 42 that are arranged in a central part of the region where the two unit pixel group regions 40 are lined up. Therefore, a similar effect to the layout arrangement of Fig. 32 is produced.

Fig. 39 is a plan layout view of the second substrate 52 according to a seventh modification of Fig. 32. As shown in Fig. 39, the region in which two unit pixel group regions 40 of the second substrate 52 according to the seventh modification are lined up has a layout configuration in which the first row and the second row in Fig. 38 have been swapped and the fourth row and the fifth row in Fig. 38 have been swapped.

Even in Fig. 39, the gates SR and SD of the first and second sampling transistors 33 and 34 are arranged in point symmetry or line symmetry with respect to the gates SF2 of the two second source follower circuit 42 that are arranged in a central part of the region where the two unit pixel group regions 40 are lined up. Therefore, a similar effect to the layout arrangement of Fig. 32 is produced.

Fig. 40 is a circuit diagram in a case where two pixels 15 and two first pixel circuits 16 share one second pixel circuit 17 using the pixel 15, the first pixel circuit 16, and the second pixel circuit 17 according to the circuit configuration shown in Fig. 21. As shown in Fig. 40, the two pixels 15 and the two first pixel circuits 16 arranged in the second direction Y are objects to be shared, and the two first pixel circuits 16 and the one second pixel circuit 17 share the second floating diffusion region FD2. Fig. 31 illustrates circuit configurations of four pixels, in which the two (upper and lower) first pixel circuits 16 on a left side are connected to one second pixel circuit 17 and the two (upper and lower) first pixel circuits 16 on a right side are connected to one other second pixel circuit 17.

Fig. 41 is a plan layout view of a region in which two unit pixel group regions 40 for 1 × 2 pixels of the second substrate 52 that is constituted of the pixel 15 and the pixel circuits shown in Fig. 40 are lined up. The region shown in Fig. 41 in which two unit pixel group regions 40 are lined up includes five rows (first to fifth rows). In the first and fifth rows, the gates VB and PC of the transistor groups 35 and 36 that constitute current sources, the well contact region WC, and the gates PC and VB of the transistor groups 35 and 36 that constitute current sources are arranged along the first direction X in this order with the diffusion layer 37 sandwiched between the respective gates. In the second and fourth rows, the gate PSEL of the third selective transistor 38, the gate SD of the second sampling transistor 34, the gate SR of the first sampling transistor 33, the gate SR of the first sampling transistor 33, the gate SD of the second sampling transistor 34, and the gate PSEL of the third selective transistor 38 are arranged along the first direction X in this order with the diffusion layer 37 sandwiched between the respective gates. In the third row, the gate SEL of the second selective transistor 44, the gate SF2 of the second source follower circuit 42, the gate SF2 of the second source follower circuit 42, and the gate SEL of the second selective transistor 44 are arranged along the first direction X in this order.

In Fig. 41, the gates SF2 of the two second source follower circuits 42 are arranged along the first direction X in the central part in the second direction Y in the region where the two unit pixel group regions 40 are lined up, and the gates SR and SD of the first and second sampling transistors 33 and 34 of two pixels are arranged in point symmetry or line symmetry with respect to the gates SF2.

Accordingly, the distances between the gates SF2 of the second source follower circuits 42 and the gates SR of the two first sampling transistors 33 become uniform and the distances between the gates SF2 of the second source follower circuits 42 and the gates SD of the two second sampling transistors 33 become uniform. Therefore, an effect of crosstalk becomes the same in all pixels 15 and a difference in output among colors can be eliminated.

Fig. 42 is a plan layout view of the second substrate 52 according to a first modification of Fig. 41. As shown in Fig. 42, the region in which two unit pixel group regions 40 of the second substrate 52 according to the first modification are lined up has a layout configuration in which the first row and the second row in Fig. 41 have been swapped and the fourth row and the fifth row in Fig. 41 have been swapped.

Even in Fig. 42, the gates SR and SD of the first and second sampling transistors 33 and 34 are arranged in point symmetry or line symmetry with respect to the gates SF2 of the two second source follower circuit 42 that are arranged in a central part of the region where the two unit pixel group regions 40 are lined up. Therefore, a similar effect to the layout arrangement of Fig. 32 is produced.

Fig. 43 is a plan layout view of the second substrate 52 according to a second modification of Fig. 41. As shown in Fig. 43, the region in which two unit pixel group regions 40 of the second substrate 52 according to the second modification are lined up includes five columns (first to fifth columns) and one row.

In the first and fifth columns, the gates VB, PC, PC, and VB of the two transistor groups 35 and 36 that constitute current sources are arranged along the second direction Y in this order with the diffusion layer 37 sandwiched between the respective gates. In the second and fourth columns, the gate PSEL of the third selective transistor 38, the gate SD of the second sampling transistor 34, the gate SR of the first sampling transistor 33, the gate SR of the first sampling transistor 33, the gate SD of the second sampling transistor 34, and the gate PSEL of the third selective transistor 38 are arranged along the second direction Y in this order with the diffusion layer 37 sandwiched between the respective gates. Two well contact regions WC are arranged along the second direction Y in the third column. In the one row arranged in the central part in the second direction Y of the unit pixel group region 40, the gate SEL of the second selective transistor 44, the gate SF2 of the second source follower circuit 42, the gate SF2 of the second source follower circuit 42, and the gate SEL of the second selective transistor 44 are arranged along the first direction X in this order.

Even in Fig. 43, the gates SR and SD of the first and second sampling transistors 33 and 34 are arranged in point symmetry or line symmetry with respect to the gates SF2 of the two second source follower circuit 42 that are arranged in a central part of the region where the two unit pixel group regions 40 are lined up. Therefore, a similar effect to the layout arrangement of Fig. 32 is produced.

Fig. 44 is a plan layout view of the second substrate 52 according to a third modification of Fig. 41. As shown in Fig. 44, the region in which two unit pixel group regions 40 of the second substrate 52 according to the third modification are lined up has a layout arrangement in which the first column and the second column have been swapped and the fourth column and the fifth column have been swapped.

Even in Fig. 44, the gates SR and SD of the first and second sampling transistors 33 and 34 are arranged in point symmetry or line symmetry with respect to the gates SF2 of the two second source follower circuit 42 that are arranged in a central part of the region where the two unit pixel group regions 40 are lined up. Therefore, a similar effect to the layout arrangement of Fig. 32 is produced.

Fig. 45 is a plan layout view of the second substrate 52 according to a fourth modification of Fig. 41. As shown in Fig. 45, the region in which two unit pixel group regions 40 of the second substrate 52 according to the fourth modification are lined up includes five columns (first to fifth columns) and one row.

In the first and fifth columns, the gates VB, PC, PC, and VB of the transistor groups 35 and 36 that constitute current sources are arranged along the second direction Y in this order with the diffusion layer 37 sandwiched between the respective gates. In the second and fourth columns, the gate PSEL of the third selective transistor 38, the gate SD of the second sampling transistor 34, the gate SR of the first sampling transistor 33, the gate SR of the first sampling transistor 33, and the gate SD of the second sampling transistor 34 are arranged along the second direction Y in this order with the diffusion layer 37 sandwiched between the respective gates. Two well contact regions WC are arranged along the second direction Y in the third column. In the one row arranged in the central part in the second direction of the unit pixel group region 40, the gate SEL of the second selective transistor 44, the gate SF2 of the second source follower circuit 42, the gate SF2 of the second source follower circuit 42, and the gate SEL of the second selective transistor 44 are arranged along the first direction X.

Even in Fig. 45, the gates SR and SD of the first and second sampling transistors 33 and 34 are arranged in point symmetry or line symmetry with respect to the gates SF2 of the two second source follower circuit 42 that are arranged in a central part of the region where the two unit pixel group regions 40 are lined up. Therefore, a similar effect to the layout arrangement of Fig. 32 is produced.

Fig. 46 is a plan layout view of the second substrate 52 according to a fifth modification of Fig. 41. As shown in Fig. 46, the region in which two unit pixel group regions 40 of the second substrate 52 according to the fifth modification are lined up has a layout arrangement in which the first column and the second column in Fig. 45 have been swapped and the fourth column and the fifth column in Fig. 45 have been swapped.

Even in Fig. 46, the gates SR and SD of the first and second sampling transistors 33 and 34 are arranged in point symmetry or line symmetry with respect to the gates SF2 of the two second source follower circuit 42 that are arranged in a central part of the region where the two unit pixel group regions 40 are lined up. Therefore, a similar effect to the layout arrangement of Fig. 32 is produced.

Fig. 47 is a plan layout view of the second substrate 52 according to a sixth modification of Fig. 41. As shown in Fig. 47, the region in which two unit pixel group regions 40 of the second substrate 52 according to the sixth modification are lined up includes five rows (first to fifth rows).

In the first and fifth rows, the gates VB and PC of the transistor groups 35 and 36 that constitute current sources, the well contact region WC, and the gates PC and VB of the transistor groups 35 and 36 that constitute current sources are arranged along the first direction X in this order with the diffusion layer 37 sandwiched between the respective gates. In the second and fourth rows, the gate PSEL of the third selective transistor 38, the gate SD of the second sampling transistor 34, the gate SR of the first sampling transistor 33, the gate SR of the first sampling transistor 33, the gate SD of the second sampling transistor 34, and the gate PSEL of the third selective transistor 38 are arranged along the first direction X in this order with the diffusion layer 37 sandwiched between the respective gates. In the third row, the gate SEL of the second selective transistor 44, the gate SF2 of the second source follower circuit 42, the gate SF2 of the second source follower circuit 42, and the gate SEL of the second selective transistor 44 are arranged along the first direction X in this order.

Even in Fig. 47, the gates SR and SD of the first and second sampling transistors 33 and 34 are arranged in point symmetry or line symmetry with respect to the gates SF2 of the two second source follower circuit 42 that are arranged in a central part of the region where the two unit pixel group regions 40 are lined up. Therefore, a similar effect to the layout arrangement of Fig. 32 is produced.

Fig. 48 is a plan layout view of the second substrate 52 according to a sixth modification of Fig. 41. As shown in Fig. 47, the region in which two unit pixel group regions 40 of the second substrate 52 according to the sixth modification are lined up has a layout configuration in which the first row and the second row in Fig. 47 have been swapped and the fourth row and the fifth row in Fig. 47 have been swapped.

Even in Fig. 48, the gates SR and SD of the first and second sampling transistors 33 and 34 are arranged in point symmetry or line symmetry with respect to the gates SF2 of the two second source follower circuit 42 that are arranged in a central part of the region where the two unit pixel group regions 40 are lined up. Therefore, a similar effect to the layout arrangement of Fig. 32 is produced.

As described above, the first substrate 51 and the second substrate 52 transmit and receive signals due to joining of the first metal pads 63 and the second metal pads 68 and the second substrate 52 and the third substrate 53 transmit and receive signals due to joining of the third metal pads 71 arranged at the end of the TSV 70 that extends from the second substrate 52 toward the third substrate 53 and the fourth metal pads 75 of the third substrate 53. Arrangement locations and sizes of the metal pads are arbitrary.

Fig. 49 is a plan layout view showing an example of a junction location of the first metal pad 63 and the second metal pad 68 and an arrangement location of the TSV 70 on the second substrate 52. While the junction location of the first metal pad 63 and the second pad is provided for each pixel 15, one TSV 70 is provided for each unit pixel group region 40 made up of a plurality of (for example, four) pixels 15. Therefore, for example, as shown in Fig. 49, conceivably, the junction location of the first metal pad 63 and the second metal pad 68 may be arranged in a central part of a region of each pixel 15 and the TSV 70 may be arranged in a central part of a boundary edge in the first direction X of the unit pixel group region 40. Fig. 49 represents an example of an arrangement location and sizes of the first metal pad 63, the second metal pad 68, and the TSV 70 and may assume various modifications.

Specific circuit configurations of the pixel 15 and the pixel circuits are not limited to the circuit configurations shown in Fig. 3 or 15 and various circuit configurations can be applied.

Fig. 50 is a circuit diagram of the pixel 15, the first pixel circuit 16, and the second pixel circuit 17 according to a first modification. Fig. 50 differs from Figs. 3 and 21 in a circuit configuration of the first pixel circuit 16. Note that while the discharge transistor 30 and the conversion efficiency switching transistor 27 in the pixel 15 are omitted in Fig. 50, the transistors may be provided and the configuration of the pixel 15 is substantially the same as in Fig. 3.

The first pixel circuit 16 according to Fig. 50 has a sample-and-hold transistor 83 in addition to the first capacitative element 31 and the second capacitative element 32, the first sampling transistor 33 and the second sampling transistor 34, and the transistor groups 35 and 36 that constitute current sources.

The sample-and-hold transistor 83 is connected between the output node n1 of the pixel 15 and the output node n2 of the first pixel circuit 16. The first capacitative element 31 and the first sampling transistor 33 are connected in series between a reference voltage node (for example, a power supply voltage node) and the output node n2 of the first pixel circuit 16. The second capacitative element 32 and the second sampling transistor 34 are connected in series between the reference voltage node and the output node n2 of the first pixel circuit 16.

Fig. 51 is a circuit diagram of the pixel 15, the first pixel circuit 16, and the second pixel circuit 17 according to a second modification. Fig. 51 includes the pixel 15 of which a circuit configuration is substantially the same as Fig. 3 and the first pixel circuit 16 of which a circuit configuration differs from Fig. 3.

The first pixel circuit 16 shown in Fig. 51 has the first and second sampling transistors 33 and 34, the first capacitative element 31, and the second capacitative element 32.

The first sampling transistor 33 and the second capacitative element 32 are connected in series between the output node n1 of the pixel 15 and the output node n2 of the first pixel circuit 16. The first capacitative element 31 is connected between a reference voltage node (for example, a power supply voltage node) and the output node n2 of the first pixel circuit 16. The second sampling transistor 34 is connected between the reference voltage node and the output node n2 of the first pixel circuit 16.

Fig. 52 is a circuit diagram of the pixel 15, the first pixel circuit 16, and the second pixel circuit 17 according to a third modification. Fig. 52 includes the pixel 15 of which a circuit configuration is substantially the same as Fig. 3 and the first pixel circuit 16 and the second pixel circuit 17 of which a circuit configuration differs from Fig. 3.

The first pixel circuit 16 in Fig. 52 has the transistor 35 that constitutes a current source connected between the output node n1 of the pixel 15 and a reference voltage node (for example, a ground node), the first sampling transistor 33 and the second sampling transistor 34 that are cascode-connected between the output node n1 of the pixel 15 and the output node n2 of the first pixel circuit 16, the first capacitative element 31 connected between a connection node of the first sampling transistor 33 and the second sampling transistor 34 and the reference voltage node (for example, a ground node), and the second capacitative element 32 connected between the output node n2 of the first pixel circuit 16 and the reference voltage node (for example, a ground node).

The second pixel circuit 17 in Fig. 52 has the second source follower circuit 42 (second amplifying transistor 43) and the second selective transistor 44 that are cascode-connected between a reference voltage node (for example, a power supply voltage node) and the vertical signal line VSL. While the second pixel circuit 17 in Fig. 53 does not have the second reset transistor 41 in Fig. 3, the second reset transistor 41 may be added.

Fig. 53 is a circuit diagram of the pixel 15, the first pixel circuit 16, and the second pixel circuit 17 according to a fourth modification. Fig. 52 includes the pixel 15 of which a circuit configuration is substantially the same as Fig. 3 and the first pixel circuit 16 of which a circuit configuration differs from Fig. 3.

The first pixel circuit 16 in Fig. 53 has the transistor 35 that constitutes a current source connected between the output node n1 of the pixel 15 and a reference voltage node (for example, a ground node), the first capacitative element 31 connected between the output node n1 of the pixel 15 and the output node n2 of the first pixel circuit 16, and the second capacitative element 32 connected between the output node n2 of the first pixel circuit 16 and the reference voltage node (for example, a ground node).

While the first pixel circuit 16 according to Fig. 3, Fig. 21, and the first to fourth modifications includes a current source connected between the output node n1 of the pixel 15 and the reference voltage node (for example, a ground node), the current source may be constituted of the transistor groups 35 and 36 or constituted of the individual transistor 35. In addition, whether or not the conversion efficiency switching transistor 27 and the discharge transistor 30 are to be provided in the pixel 15 is also optional.

While an example in which the light detection device 3 has a three-layer structure of the first substrate 51 to the third substrate 53 has been shown in Fig. 5, the light detection device 3 can also have a two-layer structure of the first substrate 51 and the second substrate. In this case, for example, a plurality of the pixels 15, a plurality of the first pixel circuits 16, and a plurality of the second pixel circuits 17 are arranged on the first substrate 51 and the logic circuit 54 is arranged on the second substrate 52.

As described above, the light detection device 3 according to the present embodiment adopts a global shutter system and has the first capacitative element 31 and the second capacitative element 32 that simultaneously start exposure of all pixels 15 and hold a voltage signal in accordance with an electric charge accumulated in the photoelectric conversion element 21. The light detection device 3 according to the present embodiment is constructed by laminating two or three substrates. There is a risk that each gate of the first sampling transistor 33 and the second sampling transistor 34 which perform control so as to hold voltage signals in the first capacitative element 31 and the second capacitative element 32 may cause crosstalk to occur in the channel directly below the gate SF2 of the second source follower circuit 42 in a subsequent stage. In particular, when a plurality of pixels 15 and a plurality of first pixel circuits 16 share one second pixel circuit 17, if distances from the gates SR and SD of the first and second sampling transistors 33 and 34 to the gate SF2 of the second source follower circuit 42 differ for each shared pixel, a magnitude of the crosstalk also varies for each pixel and may cause image quality to decline. In consideration thereof, in the present embodiment, when one second pixel circuit 17 is shared by a plurality of pixels 15 and a plurality of first pixel circuits 16, each gate of a plurality of first and second sampling transistors 33 and 34 are arranged at a position in point symmetry or line symmetry with respect to the gate of the second source follower circuit 42. Accordingly, crosstalk imparted by the first sampling transistor 33 and the second sampling transistor 34 of each shared pixel to a channel directly below the gate SF2 of the second source follower circuit 42 can be made uniform and an improvement in image quality can be achieved.

### <Example of application to mobile body>

The technique according to the present disclosure (the present technique) can be applied to various products. For example, the technique according to the present disclosure may be realized as an device to be mounted to any of various types of mobile bodies including an automobile, an electric vehicle, a hybrid electric vehicle, a motorcycle, a bicycle, personal mobility, an airplane, a drone, an ocean vessel, and a robot.

Fig. 54 is a block diagram showing a schematic configuration example of a vehicle control system that represents an example of a mobile body control system to which the technique according to the present disclosure may be applied.

A vehicle control system 12000 includes a plurality of electronic control units that are connected via a communication network 12001. In the example shown in Fig. 54, the vehicle control system 12000 includes a drive system control unit 12010, a body system control unit 12020, an external vehicle information detecting unit 12030, an internal vehicle information detecting unit 12040, and an integrated control unit 12050. In addition, as functional components of the integrated control unit 12050, a microcomputer 12051, an audio/video output portion 12052, and a vehicle-mounted network I/F (Interface) 12053 are illustrated.

The drive system control unit 12010 controls operations of devices related to a drive system of a vehicle in accordance with various programs. For example, the drive system control unit 12010 functions as a control device of a drive force generation device for generating a drive force of the vehicle such as an internal engine or a drive motor, a control device of a drive force transmission mechanism for transmitting the drive force to wheels, a control device of a steering mechanism for adjusting a steering angle of the vehicle, and a control device of a braking device that generates a brake force of the vehicle.

The body system control unit 12020 controls operations of various devices mounted to the vehicle body in accordance with various programs. For example, the body system control unit 12020 functions as a control device of a key-less entry system, a smart key system, a power window device, or various lamps such as head lamps, tail lamps, brake lamps, turn indicators, and fog lamps. In this case, radio waves or signals of various switches which are transmitted from a portable device that substitutes as a key may be input to the body system control unit 12020. The body system control unit 12020 accepts input of the radio waves or signals and controls a door lock device, the power window device, the lamps, and the like of the vehicle.

The external vehicle information detecting unit 12030 detects information on an exterior of the vehicle that is mounted with the vehicle control system 12000. For example, an imaging portion 12031 is connected to the external vehicle information detecting unit 12030. The external vehicle information detecting unit 12030 causes the imaging portion 12031 to capture an image of the exterior of the vehicle and receives the captured image. Based on the received image, the external vehicle information detecting unit 12030 may perform object detection processing or distance detection processing with respect to people, vehicles, obstacles, signs, letters on road surfaces, and the like.

The imaging portion 12031 is a light sensor which receives light and which outputs an electric signal in accordance with an amount of the received light. The imaging portion 12031 can output the electric signal as an image or as ranging information. In addition, the light received by the imaging portion 12031 may be visible light or invisible light such as infrared light.

The internal vehicle information detecting unit 12040 detects information on an interior of the vehicle. For example, a driver state detecting portion 12041 that detects a state of a driver is connected to the internal vehicle information detecting unit 12040. For example, the driver state detecting portion 12041 includes a camera for capturing an image of the driver and, based on detection information that is input from the driver state detecting portion 12041, the internal vehicle information detecting unit 12040 may calculate a degree of fatigue or a degree of concentration of the driver or may determine whether or not the driver has fallen asleep.

Based on information on the exterior or the interior of the vehicle acquired by the external vehicle information detecting unit 12030 or the internal vehicle information detecting unit 12040, the microcomputer 12051 can calculate a control target value of the drive force generation device, the steering mechanism, or the brake device and output a control command to the drive system control unit 12010. For example, the microcomputer 12051 can perform cooperative control for the purpose of realizing functions of an ADAS (Advanced Driver Assistance System) including collision avoidance or crash mitigation of the vehicle, headway control based on an inter-vehicular distance, cruise control, a collision warning of the vehicle, and a lane departure warning of the vehicle.

In addition, by controlling the drive force generation device, the steering mechanism, the brake device, or the like based on information on a periphery of the vehicle acquired by the external vehicle information detecting unit 12030 or the internal vehicle information detecting unit 12040, the microcomputer 12051 can perform cooperative control for the purpose of automated driving or the like that enables the vehicle to travel autonomously without having to rely on operations by the driver.

Furthermore, based on information on the exterior of the vehicle acquired by the external vehicle information detecting unit 12030, the microcomputer 12051 can output a control command to the body system control unit 12030. For example, the microcomputer 12051 can perform cooperative control for the purpose of controlling the head lamps in accordance with a position of a vehicle ahead or an oncoming vehicle as detected by the external vehicle information detecting unit 12030 and realizing antidazzle by switching a high beam to a low beam or the like.

The audio/video output portion 12052 transmits an output signal of at least one of sound and an image to an output device that is capable of audibly or visually notifying a passenger of the vehicle or the outside of the vehicle with information. In an example shown in Fig. 54, an audio speaker 12061, a display portion 12062, and an instrument panel 12063 are exemplified as output devices. For example, the display portion 12062 may include at least one of an on-board display and a head-up display.

Fig. 55 is a diagram showing an example of an installation position of the imaging portion 12031.

In Fig. 55, as the imaging portion 12031, a vehicle 12100 has imaging portions 12101, 12102, 12103, 12104, and 12105.

For example, the imaging portions 12101, 12102, 12103, 12104, and 12105 are provided at positions such as a front nose, side mirrors, a rear bumper, a rear door, and an upper part of a front glass inside a cabin of the vehicle 12100. The imaging portion 12101 that is provided on the front nose and the imaging portion 12105 that is provided in the upper part of the front glass inside the cabin mainly acquire an image of the front of the vehicle 12100. The imaging portions 12102 and 12103 that are provided on the side mirrors mainly acquire an image of the sides of the vehicle 12100. The imaging portion 12104 that is provided on the rear bumper or the rear door mainly acquires an image of the rear of the vehicle 12100. The imaging portion 12105 that is provided in the upper part of the front glass inside the cabin is mainly used to detect vehicles ahead, pedestrians, obstacles, traffic lights, traffic signs, lanes, and the like.

Fig. 55 shows an example of photographic ranges of the imaging portions 12101 to 12104. An imaging range 12111 represents an imaging range of the imaging portion 12101 that is provided on the front nose, imaging ranges 12112 and 12113 respectively represent imaging ranges of the imaging portions 12102 and 12103 that are provided on the side mirrors, and an imaging range 12114 represents an imaging range of the imaging portion 12104 that is provided on the rear bumper or the rear door. For example, by superimposing image data captured by the imaging portions 12101 to 12104, a bird's-eye view image of the vehicle 12100 as viewed from above is obtained.

At least one of the imaging portions 12101 to 12104 may have a function of acquiring distance information. For example, at least one of the imaging portions 12101 to 12104 may be a stereo camera constituted of a plurality of imaging elements or an imaging element having pixels for phase difference detection.

For example, by obtaining a distance to each solid object in the imaging ranges 12111 to 12114 and a temporal variation of the distance (a relative speed with respect to the vehicle 12100) based on the distance information obtained from the imaging portions 12101 to 12104, particularly, the microcomputer 12051 can extract, as a vehicle ahead, a solid object which is closest to the vehicle 12100 on a path of the vehicle 12100 and which is traveling at a predetermined speed (for example, 0 km/h or higher) in approximately the same direction as the vehicle 12100. In addition, the microcomputer 12051 can set an inter-vehicular distance to be secured in advance behind a vehicle ahead and perform automatic brake control (including cruise stop control), automatic acceleration control (including cruise start control), and the like. As described above, cooperative control for the purpose of automated driving or the like that enables autonomous travel without having to rely on operations by the driver can be performed.

For example, based on the distance information obtained from the imaging portions 12101 to 12104, the microcomputer 12051 can extract solid object data related to solid objects by classifying the solid objects into motorcycles, ordinary vehicles, large vehicles, pedestrians, utility poles, and other solid objects and use the solid object data for automatic obstacle avoidance. For example, the microcomputer 12051 distinguishes obstacles around the vehicle 12100 between obstacles that are visible from the driver of the vehicle 12100 and obstacles that are hardly visible. In addition, the microcomputer 12051 can perform driving support for collision avoidance by determining a collision risk that indicates a degree of danger of a collision with each obstacle, and in a situation where the collision risk is equal to or higher than a set value and where there is a possibility of a collision, issuing a warning to the driver via the audio speaker 12061 or the display portion 12062 or performing forced braking or evasive steering via the drive system control unit 12010.

At least one of the imaging portions 12101 to 12104 may be an infrared camera that detects infrared light. For example, the microcomputer 12051 can recognize a pedestrian by determining whether or not a pedestrian is present in a captured image of the imaging portions 12101 to 12104. The recognition of a pedestrian is performed by a step of extracting a feature point in a captured image of the imaging portions 12101 to 12104 as an infrared camera and a step of performing pattern matching on a series of feature points indicating a contour of an object to determine whether or not the object is a pedestrian. When the microcomputer 12051 determines that a pedestrian is present in a captured image of the imaging portions 12101 to 12104 and recognizes the pedestrian, the audio/video output portion 12052 controls the display portion 12062 so that a rectangular contour line for highlighting is superimposed and displayed on the recognized pedestrian. In addition, the audio/video output portion 12052 may control the display portion 12062 so that an icon or the like which represents a pedestrian is displayed at a desired position.

This concludes the description of an example of a vehicle control system to which the technique according to the present disclosure may be applied. The technique according to the present disclosure may be applied to, for example, the imaging portion 12031 and the like among the configuration described above. Specifically, the light detection device 3 according to the present embodiment can be applied to the imaging portion 12031."and the like. By applying the technique according to the present disclosure to the imaging portion 12031, since a clearer photographed image can be obtained, fatigue of a driver can be reduced.

### <Example of application to endoscopic surgery system>

The technique according to the present disclosure (the present technique) can be applied to various products. For example, the technique according to the present disclosure can be applied to an endoscopic surgery system.

Fig. 56 is a diagram showing an example of a schematic configuration of an endoscopic surgery system to which the technique according to the present disclosure (the present technique) may be applied.

Fig. 56 shows a situation where an operator (a medical doctor) 11131 is performing a surgery on a patient 11132 on a patient bed 11133 using an endoscopic surgery system 11000. As illustrated, the endoscopic surgery system 11000 is constituted of an endoscope 11100, other surgical tools 11110 such as a pneumoperitoneum tube 11111 and an energized treatment tool 11112, a support arm device 11120 for supporting the endoscope 11100, and a cart 11200 mounted with various devices for an endoscopic surgery.

The endoscope 11100 is constituted of a lens tube 11101 of which a region of a predetermined length from a tip is to be inserted into the body cavity of the patient 11132 and a camera head 11102 that is connected to a base end of the lens tube 11101. While the illustrated example represents the endoscope 11100 that is configured as a so-called rigid scope having a rigid lens tube 11101, alternatively, the endoscope 11100 may be configured as a so-called flexible scope having a flexible lens tube.

An opening fitted with an objective lens is provided at the tip of the lens tube 11101. A light source device 11203 is connected to the endoscope 11100, and light generated by the light source device 11203 is guided to the tip of the lens tube 11101 by a light guide that is provided so as to extend inside the lens tube and irradiated via the objective lens toward an observation target inside the body cavity of the patient 11132. It should be noted that the endoscope 11100 may be a forward-viewing endoscope, an angled endoscope, or a lateralviewing endoscope.

An optical system and an imaging element are provided inside the camera head 11102, and reflected light (observation light) from the observation target is collected on the imaging element by the optical system. The observation light is photoelectrically converted by the imaging element and an electric signal corresponding to the observation light or, in other words, an image signal corresponding to an observation image is generated. The image signal is transmitted to a camera control unit (CCU) 11201 as RAW data.

The CCU 11201 is constituted of a CPU (Central Processing Unit), a GPU (Graphics Processing Unit), and the like and comprehensively controls operations of the endoscope 11100 and a display device 11202. Furthermore, the CCU 11201 receives the image signal from the camera head 11102 and subjects the image signal to various kinds of image processing for displaying an image based on the image signal such as development processing (demosaicking).

Under the control of the CCU 11201, the display device 11202 displays an image based on the image signal having been subject to image processing by the CCU 11201.

For example, the light source device 11203 is constituted of a light source such as an LED (light emitting diode) and supplies the endoscope 11100 with irradiating light when photographing an operative site and the like.

An input device 11204 is an input interface with respect to the endoscopic surgery system 11000. The user can input various kinds of information and various instructions to the endoscopic surgery system 11000 via the input device 11204. For example, the user inputs an instruction or the like to change imaging conditions (a type of irradiation light, a magnification, a focal length, and the like) of the endoscope 11100.

A treatment tool control device 11205 controls drive of the energized treatment tool 11112 for cauterizing or incising tissue, sealing a blood vessel, or the like. A pneumoperitoneum device 11206 feeds gas into the body cavity of the patient 11132 via the pneumoperitoneum tube 11111 in order to expand the body cavity for the purpose of securing a field of view of the endoscope 11100 and securing a work space for the operator. A recorder 11207 is an device that is capable of recording various kinds of information related to the surgery. A printer 11208 is an device that is capable of printing various kinds of information related to the surgery in various formats such as a text, an image, and a graph.

The light source device 11203 that supplies irradiation light to the endoscope 11100 when photographing an operative site can be constituted of a white light source that is an LED, a laser light source, or a combination thereof. When a white light source is constituted of a combination of RGB laser light sources, since output intensity and an output timing of each color (each wavelength) can be controlled with high accuracy, white balance of a captured image can be adjusted by the light source device 11203. In addition, in this case, by irradiating the observation target with laser light from each of the RGB laser light sources by time division and controlling drive of the imaging element of the camera head 11102 in synchronization with the irradiation timings, an image corresponding to each of RGB can be captured by time division. According to the method, a color image can be obtained without providing the imaging element with a color filter.

In addition, drive of the light source device 11203 may be controlled so that intensity of output light changes at predetermined time intervals. By controlling drive of the imaging element of the camera head 11102 in synchronization with a timing of change of the intensity of light to acquire images by time division and by compositing the images, an image with a high dynamic range with no so-called blocked-up shadows or blown-out highlights can be generated.

Furthermore, the light source device 11203 may be configured to be capable of supplying light of a predetermined wavelength band that corresponds to special light observation. In special light observation, for example, by utilizing wavelength dependency of absorption of light of body tissue to irradiate light with a narrower band than irradiating light (in other words, white light) during a normal observation, so-called narrow band light observation (Narrow Band Imaging) is performed in which predetermined tissue such as a capillary in a mucous membrane surface layer is photographed in high contrast. Alternatively, in special light observation, fluorescent observation in which an image is obtained by fluorescent light generated by irradiating excitation light may be performed. In fluorescent observation, body tissue can be irradiated with excitation light and fluorescence from the body tissue can be observed (self-fluorescent observation) or an agent such as indocyanine green (ICG) can be locally injected into body tissue and the body tissue may be irradiated with excitation light corresponding to a fluorescent wavelength of the agent to obtain a fluorescent image. The light source device 11203 can be configured to be capable of supplying narrow band light and/or excitation light that accommodates such special light observation.

Fig. 57 is a block diagram showing an example of functional configurations of the camera head 11102 and the CCU 11201 shown in Fig. 56.

The camera head 11102 has a lens unit 11401, an imaging portion 11402, a drive portion 11403, a communication portion 11404, and a camera head control portion 11405. The CCU 11201 has a communication portion 11411, an image processing portion 11412, and a control portion 11413. The camera head 11102 and the CCU 11201 are connected by a transmission cable 11400 so as to be capable of communicating with each other.

The lens unit 11401 is an optical system that is provided in a connecting portion with the lens tube 11101. Observation light taken in from a tip of the lens tube 11101 is guided to the camera head 11102 and input to the lens unit 11401. The lens unit 11401 is constructed by combining a plurality of lenses including a zoom lens and a focus lens.

The imaging portion 11402 may be constituted of a single imaging element (a so-called single-plate imaging element) or a plurality of image elements (a so-called multi-plate imaging element). When the imaging portion 11402 is constituted of a multi-plate imaging element, for example, an image signal corresponding to each of RGB may be generated by each imaging element and the image signals may be composited to produce a color image. Alternatively, the imaging portion 11402 may be configured to have a pair of imaging elements for respectively acquiring right-eye and left-eye image signals that correspond to 3D (dimensional) display. Performing 3D display enables the operator 11131 to more accurately assess a depth of body tissue in the operative site. When the imaging portion 11402 is constituted of a multi-plate imaging element, the lens unit 11401 is also provided in a plurality of systems in correspondence with the respective imaging elements.

In addition, the imaging portion 11402 need not necessarily be provided in the camera head 11102. For example, the imaging portion 11402 may be provided immediately behind an objective lens inside the lens tube 11101.

The drive portion 11403 is constituted of an actuator and, under control from the camera head control portion 11405, moves the zoom lens and the focus lens of the lens unit 11401 by a predetermined distance along an optical axis. Accordingly, a magnification and a focus of a captured image by the imaging portion 11402 can be appropriately adjusted.

The communication portion 11404 is constituted of a communication device for transmitting and receiving various kinds of information to and from the CCU 11201. The communication portion 11404 transmits an image signal obtained from the imaging portion 11402 to the CCU 11201 via the transmission cable 11400 as RAW data.

In addition, the communication portion 11404 receives a control signal for controlling drive of the camera head 11102 from the CCU 11201 and supplies the camera head control portion 11405 with the control signal. The control signal includes information related to imaging conditions such as information that designates a frame rate of a captured image, information that designates an exposure value during imaging, and/or information that designates a magnification and a focal point of the captured image.

It should be noted that the imaging conditions such as a frame rate, an exposure value, a magnification, and a focal point described above may be appropriately designated by the user or automatically set by the control portion 11413 of the CCU 11201 based on an acquired image signal. In the case of the latter, the endoscope 11100 is to be mounted with a so-called AE (Auto Exposure) function, AF (Auto Focus) function, and AWB (Auto White Balance) function.

Based on the control signal from the CCU 11201 received via the communication portion 11404, the camera head control portion 11405 controls drive of the camera head 11102.

The communication portion 11411 is constituted of a communication device for transmitting and receiving various kinds of information to and from the camera head 11102. The communication portion 11411 receives an image signal transmitted from the camera head 11102 via the transmission cable 11400.

In addition, the communication portion 11411 transmits, to the camera head 11102, a control signal for controlling drive of the camera head 11102. The image signal and the control signal can be transmitted by electric communication or optical communication.

The image processing portion 11412 performs various kinds of image processing on an image signal transmitted from the camera head 11102 that is RAW data.

The control portion 11413 performs various types of control related to imaging of an operative site or the like by the endoscope 11100 and display of a captured image that is obtained by the imaging of an operative site or the like. For example, the control portion 11413 generates a control signal for controlling drive of the camera head 11102.

In addition, based on an image signal having been subjected to image processing by the image processing portion 11412, the control portion 11413 causes the display device 11202 to display a captured image showing an operative site or the like. In doing so, the control portion 11413 may recognize various objects inside the captured image using various image recognition techniques. For example, by detecting a shape, a color, and the like of an edge of an object included in the captured image, the control portion 11413 can recognize surgical tools such as forceps, a specific biological site, a hemorrhage, and mist or the like when using the energized treatment tool 11112. When causing the display device 11202 to display the captured image, using the recognition result thereof, the control portion 11413 may cause various kinds of operation support information to be displayed so as to be superimposed on an image of the operative site. Superimposing and displaying the operation support information and presenting the same to the operator 11131 enables a load on the operator 11131 to be reduced and enables the operator 11131 to carry out the operation in a reliable manner.

The transmission cable 11400 that connects the camera head 11102 and the CCU 11201 is an electric signal cable that accommodates communication of electric signals, an optical fiber that accommodates optical communication, or a composite cable thereof.

While communication is performed in a wired manner using the transmission cable 11400 in the illustrated example, alternatively, the communication between the camera head 11102 and the CCU 11201 may be performed in a wireless manner.

This concludes the description of an example of an endoscopic surgery system to which the technique according to the present disclosure may be applied. The technique according to the present disclosure may be applied to, for example, the endoscope 11100, the camera head 11102 (the imaging portion 11402 thereof), the CCU 11201 (the image processing portion 11412 thereof), and the like among the configurations described above. Specifically, the light detection device 3 according to the present embodiment can be applied to an imaging portion 10402. By applying the technique according to the present disclosure to the imaging portion 10402, since a clearer operative site image can be obtained, an operator can more reliably confirm an operative site.

While an endoscopic surgery system has been described as an example, the technique according to the present disclosure may be applied to other systems such as microscopic surgery systems.

Note that the present technique can be configured as follows.
(1) A light detection device, including:
   a plurality of pixels each having a photoelectric conversion element configured to accumulate an electric charge in accordance with an amount of incident light;
   a plurality of first pixel circuits configured to hold, at a same timing, voltage signals in accordance with an electric charge accumulated in the plurality of pixels ;
   a plurality of second pixel circuits that are shared by each of two or more first pixel circuits among the plurality of first pixel circuits and configured to sequentially read the voltage signals held by the two or more first pixel circuits and to generate a pixel signal; and
   a logic circuit configured to perform signal processing of a plurality of the pixel signals generated by the plurality of second pixel circuits, wherein
   each of the plurality of first pixel circuits includes:
      a first capacitative element configured to hold a voltage signal output from a corresponding pixel in a state where an electric charge of a first floating diffusion region of the pixel has been initialized;
      a second capacitative element configured to hold a voltage signal output from the corresponding pixel in a state where an accumulated charge of the photoelectric conversion element has been transferred to the first floating diffusion region of the pixel;
      a first transistor configured to switch between whether or not to transfer an electric charge held in the first capacitative element to a second floating diffusion region shared by the two or more first pixel circuits; and
      a second transistor configured to switch between whether or not to transfer an electric charge held in the second capacitative element to the second floating diffusion region,
      each of the plurality of second pixel circuits includes a source follower circuit having a third transistor configured to generate a pixel signal in accordance with an electric charge of the second floating diffusion region, and
      two or more of the first transistors and two or more of the second transistors included in the two or more first pixel circuits are arranged in point symmetry or line symmetry around the one third transistor.
(2) The light detection device according to (1), including:
   for each of the two or more pixels, a unit pixel group region that has two or more of the first pixel circuits and one of the second pixel circuits, wherein
   the unit pixel group region has the third transistor and the two or more first transistors and the two or more second transistors that are arranged in point symmetry or line symmetry relative to the third transistor.
(3) The light detection device according to (2), wherein
   the third transistor is arranged in a central part of the unit pixel group region, and
   each gate of the two or more first transistors and the two or more second transistors is arranged at an equal distance from a gate of the third transistor.
(4) The light detection device according to (2) or (3), wherein
   a gate length direction of the third transistor arranged in the unit pixel group region and gate length directions of the two or more first transistors and the two or more second transistors are parallel to each other.
(5) The light detection device according to (2) or (3), wherein
   a gate length direction of the third transistor arranged in the unit pixel group region, and gate length directions of the two or more first transistors and the two or more second transistors intersect with each other.
(6) The light detection device according to any one of (2) to (5), wherein
   the unit pixel group region is a rectangular region arranged in a first direction and a second direction that intersects with the first direction,
   the unit pixel group region includes:
      a first region in which the two or more first transistors and the two or more second transistors are arranged on a single axis along the first direction; and
      a second region which is arranged separated from the first region in the second direction and in which the two or more first transistors and the two or more second transistors are arranged on a single axis along the first direction,
      the third transistor is arranged between the first region and the second region that are arranged separated from each other in the second direction, and
      the gate length directions of the first transistors, the second transistors, and the third transistor are the first direction.
(7) The light detection device according to (6), wherein
   each of the plurality of second pixel circuits includes:
   a fourth transistor configured to output the pixel signal to a signal line; and
   a fifth transistor configured to switch between whether or not to initialize an electric charge in the second floating diffusion region,
   the unit pixel group region includes
   a third region in which the fourth transistor, the third transistor, and the fifth transistor are arranged on a single axis along the first direction, and
   the third region is arranged between the first region and the second region that are arranged separated from each other in the second direction.
(8) The light detection device according to (6), wherein
   each of the plurality of first pixel circuits includes a sixth transistor and a seventh transistor configured to precharge the first capacitative element and the second capacitative element,
   the unit pixel group region includes:
      a fourth region in which two or more of the sixth transistors and two or more of the seventh transistors are arranged on a single axis along the first direction; and
      a fifth region which is arranged separated from the fourth region in the second direction and in which two or more of the sixth transistors and two or more of the seventh transistors are arranged on a single axis along the first direction, and
      the fourth region is arranged between the fourth region and the fifth region that are arranged separated from each other in the second direction.
(9) The light detection device according to (6), wherein
   the unit pixel group region is a rectangular region arranged in a first direction and a second direction that intersects with the first direction,
   the unit pixel group region includes:
      a first region in which the two or more first transistors and the two or more second transistors are arranged on a single axis along the second direction; and
      a second region which is arranged separated from the first region in the first direction and
      in which the two or more first transistors and the two or more second transistors are arranged on a single axis along the second direction,
      the third transistor is arranged between the first region and the second region that are arranged separated from each other in the first direction,
      channels of the first transistors and the second transistors are extended in the second direction, and
      a channel of the third transistor is extended in the first direction.
(10) The light detection device according to (9), wherein
   a diffusion layer of the third transistor is arranged on both sides in the second direction across a channel of the third transistor.
(11) The light detection device according to (5), wherein
   each of the plurality of second pixel circuits includes:
   a fourth transistor configured to output the pixel signal to a signal line; and
   a fifth transistor configured to switch between whether or not to initialize an electric charge in the second floating diffusion region,
   the unit pixel group region is a rectangular region arranged in a first direction and a second direction that intersects with the first direction,
   the unit pixel group region includes:
      a first region in which the two or more first transistors and the two or more second transistors are arranged on a single axis along the second direction;
      a second region which is arranged separated from the first region in the first direction and
      in which the two or more first transistors and the two or more second transistors are arranged on a single axis along the first direction; and
      a third region in which the fourth transistor, the third transistor, and the fifth transistor are arranged along the first direction, and
      the third region is arranged so as to divide the first region and the second region, which are arranged separated from each other in the first direction, in a central part of the unit pixel group region in the second direction.
(12) The light detection device according to (5), wherein
   each of the plurality of first pixel circuits includes a sixth transistor and a seventh transistor configured to precharge the first capacitative element and the second capacitative element,
   each of the plurality of second pixel circuits includes:
      a fourth transistor configured to output the pixel signal to a signal line; and
      a fifth transistor configured to switch between whether or not to initialize an electric charge in the second floating diffusion region,
      the unit pixel group region is a rectangular region arranged in a first direction and a second direction that intersects with the first direction,
      the unit pixel group region includes:
         a first region in which the two or more first transistors and the two or more second transistors are arranged on a single axis along the second direction;
         a second region which is arranged separated from the first region in the first direction and in which the two or more first transistors and the two or more second transistors are arranged on a single axis along the first direction;
         a third region in which the fourth transistor, the third transistor, and the fifth transistor are arranged along the first direction;
         a fourth region in which two or more of the sixth transistors and two or more of the seventh transistors are arranged along the first direction; and
         a fifth region which is arranged separated from the fourth region in the second direction and in which two or more of the sixth transistors and two or more of the seventh transistors are arranged along the first direction, and
         the third region is arranged between the fourth region and the fifth region that are arranged separated from each other in the second direction.
(13) The light detection device according to any one of (2) to (12), wherein
   a size of the third transistor is larger than sizes of the first transistors and the second transistors.
(14) The light detection device according to any one of (2) to (13), wherein
   the unit pixel group region has a plurality of the third transistors arranged in a central part and the two or more first transistors and the two or more second transistors that are arranged in point symmetry or line symmetry relative to the plurality of third transistors.
(15) The light detection device according to any one of (2) to (13), wherein
   the unit pixel group region includes two of the first pixel circuits in each of the first direction and the second direction and includes one of the second pixel circuits, and
   the unit pixel group region has two of the first transistors and two of the second transistors that are arranged in point symmetry or line symmetry relative to the third transistors in the central part.
(16) The light detection device according to any one of (2) to (13), wherein
   the unit pixel group region includes one of the first pixel circuits in the first direction, two of the first pixel circuits in the second direction, and one of the second pixel circuits, and
   a region in which two of the unit pixel group regions are lined up in the first direction has two of the first transistors and two of the second transistors that are arranged in point symmetry or line symmetry relative to two of the third transistors in the central part.
(17) The light detection device according to any one of (1) to (16), including:
   a first substrate on which the plurality of pixels are arranged; and
   a second substrate which is laminated on the first substrate and on which the plurality of first pixel circuits, the plurality of second pixel circuits, and the logic circuit are arranged.
(18) The light detection device according to any one of (1) to (16), including:
   a first substrate on which the plurality of pixels are arranged;
   a second substrate which is laminated on the first substrate and on which the plurality of first pixel circuits and the plurality of second pixel circuits are arranged, and
   a third substrate which is laminated on the second substrate and on which the logic circuit is arranged, wherein
   the first substrate has a plurality of first metal pads which are arranged so as to oppose the second substrate and to which output nodes of the plurality of pixels are connected,
   the second substrate has:
      a semiconductor layer arranged so as to oppose the third substrate,
      a plurality of second metal pads to be joined to the plurality of first metal pads,
      a plurality of first vias arranged so as to penetrate the semiconductor layer from the plurality of second pixel circuits, and
      a plurality of third metal pads that are arranged so as to oppose the third substrate and to be connected to the plurality of first vias,
      the third substrate has a plurality of fourth metal pads to be joined to the plurality of third metal pads, and
      each of the plurality of first vias is arranged for each of the two or more pixels.
(19) The light detection device according to any one of (1) to (18), wherein
   each of the plurality of pixels has:
   a third capacitative element configured to accumulate a part of an accumulated charge of the photoelectric conversion element;
   an eighth transistor configured to switch between whether or not to accumulate, to the third capacitative element, a part of an accumulated charge of the photoelectric conversion element ; and
   a ninth transistor configured to switch between whether or not to discard an accumulated charge of the photoelectric conversion element.
(20) An electronic apparatus, including:
   a light detection device configured to generate an image in accordance with an amount of incident light; and
   a processing portion configured to process the image, wherein
   the light detection device includes:
      a plurality of pixels each having a photoelectric conversion element configured to accumulate an electric charge in accordance with an amount of incident light;
      a plurality of first pixel circuits configured to hold, at a same timing, voltage signals in accordance with an electric charge accumulated in the plurality of pixels;
      a plurality of second pixel circuits that are shared by each of two or more first pixel circuits among the plurality of first pixel circuits and configured to sequentially read the voltage signals held by the two or more first pixel circuits and to generate a pixel signal; and
      a logic circuit configured to perform signal processing of a plurality of the pixel signals generated by the plurality of second pixel circuits,
      each of the plurality of first pixel circuits includes:
         a first capacitative element configured to hold a voltage signal output from a corresponding pixel in a state where an electric charge of a first floating diffusion region of the pixel has been initialized;
         a second capacitative element configured to hold a voltage signal output from the corresponding pixel in a state where an accumulated charge of the photoelectric conversion element has been transferred to the first floating diffusion region of the pixel;
         a first transistor configured to switch between whether or not to transfer an electric charge held in the first capacitative element to a second floating diffusion region shared by the two or more first pixel circuits; and
         a second transistor configured to switch between whether or not to transfer an electric charge held in the second capacitative element to the second floating diffusion region,
         each of the plurality of second pixel circuits includes a source follower circuit having a third transistor configured to generate a pixel signal in accordance with an electric charge of the second floating diffusion region, and
         two or more of the first transistors and two or more of the second transistors included in the two or more first pixel circuits are arranged in point symmetry or line symmetry around the one third transistor.

Aspects of the present disclosure are not limited to the individual embodiments described above and may include various modifications that can be conceived by those skilled in the art, and advantageous effects of the present disclosure are also not limited to those described above. In other words, various additions, changes, and partial deletions are possible without departing from the conceptual ideas and intent of the disclosure as derived from the contents defined in the claims and their equivalents.

### [Reference Signs List]

- 1: Electronic apparatus
- 2: Imaging lens
- 3: Light detection device
- 3: Light detection device according to embodiment
- 4: Image processing portion
- 5: Recording portion
- 6: Control portion
- 11: Pixel array portion
- 12: Vertical driving portion
- 13: And column signal processing portion
- 13: Column signal processing portion
- 14: Timing control portion
- 15: Pixel
- 16: First pixel circuit
- 17: Second pixel circuit
- 21: Photoelectric conversion element
- 22: Transfer transistor
- 23: First reset transistor
- 24: First source follower circuit
- 25: First amplifying transistor
- 26: First selective transistor
- 27: Conversion efficiency switching transistor
- 28: Electric charge holding portion
- 29: Voltage switcher
- 30: Discharge transistor
- 31: First capacitative element
- 32: Second capacitative element
- 33: First sampling transistor
- 34: Second sampling transistor
- 35: Transistor group
- 36: Transistor group
- 37: Diffusion layer
- 41: Second reset transistor
- 42: Second source follower circuit
- 43: Second amplifying transistor
- 44: Second selective transistor
- 45: Current source
- 50: First insulating layer
- 51: First substrate
- 52: Second substrate
- 53: Third substrate
- 54: Logic circuit
- 55: Peripheral circuit
- 56: First semiconductor layer
- 57: First wiring layer
- 58: Color filter
- 59: On-chip lens
- 60: Light-shielding wall
- 61: Fixed electric charge film
- 62: Concave-convex structure
- 63: First metal pad
- 64: Second semiconductor layer
- 65: Second wiring layer
- 66: Third wiring layer
- 67: Second insulating layer
- 68: Second metal pad
- 70: Through via
- 71: Third metal pad
- 72: Third semiconductor layer
- 73: Fourth wiring layer
- 74: Third insulating layer
- 75: Fourth metal pad
- 80: Sample-and-hold transistor
- 81: Electric charge holding portion
- 82: Conversion efficiency switching transistor
- 83: Sample-and-hold transistor

## Claims

1. A light detection device, comprising:
a plurality of pixels each having a photoelectric conversion element configured to accumulate an electric charge in accordance with an amount of incident light;
a plurality of first pixel circuits configured to hold, at a same timing, voltage signals in accordance with an electric charge accumulated in the plurality of pixels;
a plurality of second pixel circuits that are shared by each of two or more first pixel circuits among the plurality of first pixel circuits and configured to sequentially read the voltage signals held by the two or more first pixel circuits and to generate a pixel signal; and
a logic circuit configured to perform signal processing of a plurality of the pixel signals generated by the plurality of second pixel circuits, wherein
each of the plurality of first pixel circuits includes:
a first capacitative element configured to hold a voltage signal output from a corresponding pixel in a state where an electric charge of a first floating diffusion region of the pixel has been initialized;
a second capacitative element configured to hold a voltage signal output from the corresponding pixel in a state where an accumulated charge of the photoelectric conversion element has been transferred to the first floating diffusion region of the pixel;
a first transistor configured to switch between whether or not to transfer an electric charge held in the first capacitative element to a second floating diffusion region shared by the two or more first pixel circuits; and
a second transistor configured to switch between whether or not to transfer an electric charge held in the second capacitative element to the second floating diffusion region,
each of the plurality of second pixel circuits includes a source follower circuit having a third transistor configured to generate a pixel signal in accordance with an electric charge of the second floating diffusion region, and
two or more of the first transistors and two or more of the second transistors included in the two or more first pixel circuits are arranged in point symmetry or line symmetry around the one third transistor.

2. The light detection device according to claim 1, comprising:
for each of the two or more pixels, a unit pixel group region that has two or more of the first pixel circuits and one of the second pixel circuits, wherein
the unit pixel group region has the third transistor and the two or more first transistors and the two or more second transistors that are arranged in point symmetry or line symmetry relative to the third transistor.

3. The light detection device according to claim 2, wherein
the third transistor is arranged in a central part of the unit pixel group region, and
each gate of the two or more first transistors and the two or more second transistors is arranged at an equal distance from a gate of the third transistor.

4. The light detection device according to claim 2, wherein
a gate length direction of the third transistor arranged in the unit pixel group region and
gate length directions of the two or more first transistors and the two or more second transistors are parallel to each other.

5. The light detection device according to claim 2, wherein
a gate length direction of the third transistor arranged in the unit pixel group region, and
gate length directions of the two or more first transistors and the two or more second transistors intersect with each other.

6. The light detection device according to claim 2, wherein
the unit pixel group region is a rectangular region arranged in a first direction and a second direction that intersects with the first direction,
the unit pixel group region includes:
a first region in which the two or more first transistors and the two or more second transistors are arranged on a single axis along the first direction; and
a second region which is arranged separated from the first region in the second direction and in which the two or more first transistors and the two or more second transistors are arranged on a single axis along the first direction,
the third transistor is arranged between the first region and the second region that are arranged separated from each other in the second direction, and
the gate length directions of the first transistors, the second transistors, and the third transistor are the first direction.

7. The light detection device according to claim 6, wherein
each of the plurality of second pixel circuits includes:
a fourth transistor configured to output the pixel signal to a signal line; and
a fifth transistor configured to switch between whether or not to initialize an electric charge in the second floating diffusion region, and
the unit pixel group region includes
a third region in which the fourth transistor, the third transistor, and the fifth transistor are arranged on a single axis along the first direction, and
the third region is arranged between the first region and the second region that are arranged separated from each other in the second direction.

8. The light detection device according to claim 6, wherein
each of the plurality of first pixel circuits includes a sixth transistor and a seventh transistor configured to precharge the first capacitative element and the second capacitative element,
the unit pixel group region includes:
a fourth region in which two or more of the sixth transistors and two or more of the seventh transistors are arranged on a single axis along the first direction; and
a fifth region which is arranged separated from the fourth region in the second direction and in which two or more of the sixth transistors and two or more of the seventh transistors are arranged on a single axis along the first direction, and
the fourth region is arranged between the fourth region and the fifth region that are arranged separated from each other in the second direction.

9. The light detection device according to claim 6, wherein
the unit pixel group region is a rectangular region arranged in a first direction and a second direction that intersects with the first direction,
the unit pixel group region includes:
a first region in which the two or more first transistors and the two or more second transistors are arranged on a single axis along the second direction; and
a second region which is arranged separated from the first region in the first direction and
in which the two or more first transistors and the two or more second transistors are arranged on a single axis along the second direction,
the third transistor is arranged between the first region and the second region that are arranged separated from each other in the first direction,
channels of the first transistors and the second transistors are extended in the second direction, and
a channel of the third transistor is extended in the first direction.

10. The light detection device according to claim 9, wherein
a diffusion layer of the third transistor is arranged on both sides in the second direction across a channel of the third transistor.

11. The light detection device according to claim 5, wherein
each of the plurality of second pixel circuits includes:
a fourth transistor configured to output the pixel signal to a signal line; and
a fifth transistor configured to switch between whether or not to initialize an electric charge in the second floating diffusion region,
the unit pixel group region is a rectangular region arranged in a first direction and a second direction that intersects with the first direction,
the unit pixel group region includes:
a first region in which the two or more first transistors and the two or more second transistors are arranged on a single axis along the second direction; and
a second region which is arranged separated from the first region in the first direction and
in which the two or more first transistors and the two or more second transistors are arranged on a single axis along the first direction; and
a third region in which the fourth transistor, the third transistor, and the fifth transistor are arranged along the first direction, and
the third region is arranged so as to divide the first region and the second region, which are arranged separated from each other in the first direction, in a central part of the unit pixel group region in the second direction.

12. The light detection device according to claim 5, wherein
each of the plurality of first pixel circuits includes a sixth transistor and a seventh transistor configured to precharge the first capacitative element and the second capacitative element,
each of the plurality of second pixel circuits includes:
a fourth transistor configured to output the pixel signal to a signal line; and
a fifth transistor configured to switch between whether or not to initialize an electric charge in the second floating diffusion region,
the unit pixel group region is a rectangular region arranged in a first direction and a second direction that intersects with the first direction,
the unit pixel group region includes:
a first region in which the two or more first transistors and the two or more second transistors are arranged on a single axis along the second direction; and
a second region which is arranged separated from the first region in the first direction and in which the two or more first transistors and the two or more second transistors are arranged on a single axis along the first direction; and
a third region in which the fourth transistor, the third transistor, and the fifth transistor are arranged along the first direction;
a fourth region in which two or more of the sixth transistors and two or more of the seventh transistors are arranged along the first direction; and
a fifth region which is arranged separated from the fourth region in the second direction and in which two or more of the sixth transistors and two or more of the seventh transistors are arranged along the first direction, and
the third region is arranged between the fourth region and the fifth region that are arranged separated from each other in the second direction.

13. The light detection device according to claim 2, wherein
a size of the third transistor is larger than sizes of the first transistors and the second transistors.

14. The light detection device according to claim 2, wherein
the unit pixel group region has a plurality of the third transistors arranged in a central part and the two or more first transistors and the two or more second transistors that are arranged in point symmetry or line symmetry relative to the plurality of third transistors.

15. The light detection device according to claim 2, wherein
the unit pixel group region includes two of the first pixel circuits in each of the first direction and the second direction and includes one of the second pixel circuits, and
the unit pixel group region has two of the first transistors and two of the second transistors that are arranged in point symmetry or line symmetry relative to the third transistors in the central part.

16. The light detection device according to claim 2, wherein
the unit pixel group region includes one of the first pixel circuits in the first direction, two of the first pixel circuits in the second direction, and one of the second pixel circuits, and
a region in which two of the unit pixel group regions are lined up in the first direction has two of the first transistors and two of the second transistors that are arranged in point symmetry or line symmetry relative to two of the third transistors in the central part.

17. The light detection device according to claim 1, comprising:
a first substrate on which the plurality of pixels are arranged; and
a second substrate which is laminated on the first substrate and on which the plurality of first pixel circuits, the plurality of second pixel circuits, and the logic circuit are arranged.

18. The light detection device according to claim 1, comprising:
a first substrate on which the plurality of pixels are arranged;
a second substrate which is laminated on the first substrate and on which the plurality of first pixel circuits and the plurality of second pixel circuits are arranged, and
a third substrate which is laminated on the second substrate and on which the logic circuit is arranged, wherein
the first substrate has a plurality of first metal pads which are arranged so as to oppose the second substrate and to which output nodes of the plurality of pixels are connected,
the second substrate has:
a semiconductor layer arranged so as to oppose the third substrate,
a plurality of second metal pads to be joined to the plurality of first metal pads,
a plurality of first vias arranged so as to penetrate the semiconductor layer from the plurality of second pixel circuits, and
a plurality of third metal pads that are arranged so as to oppose the third substrate and to be connected to the plurality of first vias,
the third substrate has a plurality of fourth metal pads to be joined to the plurality of third metal pads, and
each of the plurality of first vias is arranged for each of the two or more pixels.

19. The light detection device according to claim 1, wherein
each of the plurality of pixels has:
a third capacitative element configured to accumulate a part of an accumulated charge of the photoelectric conversion element;
an eighth transistor configured to switch between whether or not to accumulate, to the third capacitative element, a part of an accumulated charge of the photoelectric conversion element ; and
a ninth transistor configured to switch between whether or not to discard an accumulated charge of the photoelectric conversion element.

20. An electronic apparatus, comprising:
a light detection device configured to generate an image in accordance with an amount of incident light; and
a processing portion configured to process the image, wherein
the light detection device includes:
a plurality of pixels each having a photoelectric conversion element configured to accumulate an electric charge in accordance with an amount of incident light;
a plurality of first pixel circuits configured to hold, at a same timing, voltage signals in accordance with an electric charge accumulated in the plurality of pixels ;
a plurality of second pixel circuits that are shared by each of two or more first pixel circuits among the plurality of first pixel circuits and configured to sequentially read the voltage signals held by the two or more first pixel circuits and to generate a pixel signal; and
a logic circuit configured to perform signal processing of a plurality of the pixel signals generated by the plurality of second pixel circuits,
each of the plurality of first pixel circuits includes:
a first capacitative element configured to hold a voltage signal output from a corresponding pixel in a state where an electric charge of a first floating diffusion region of the pixel has been initialized;
a second capacitative element configured to hold a voltage signal output from the corresponding pixel in a state where an accumulated charge of the photoelectric conversion element has been transferred to the first floating diffusion region of the pixel;
a first transistor configured to switch between whether or not to transfer an electric charge held in the first capacitative element to a second floating diffusion region shared by the two or more first pixel circuits; and
a second transistor configured to switch between whether or not to transfer an electric charge held in the second capacitative element to the second floating diffusion region,
each of the plurality of second pixel circuits includes a source follower circuit having a third transistor configured to generate a pixel signal in accordance with an electric charge of the second floating diffusion region, and
two or more of the first transistors and two or more of the second transistors included in the two or more first pixel circuits are arranged in point symmetry or line symmetry around the one third transistor.
